(19) Europäisches Patentamt
European Patent Office
Office européen des brevets

(11) EP 4 658 030 A1

(12) EUROPEAN PATENT APPLICATION
published in accordance with Art. 153(4) EPC

(43) Date of publication:
03.12.2025 Bulletin 2025/49

(51) International Patent Classification (IPC):
H10F 77/30 (2025.01)   H10F 10/14 (2025.01)
H10F 71/00 (2025.01)   C23C 16/40 (2006.01)
C23C 16/455 (2006.01)

(21) Application number: 24864291.0

(22) Date of filing: 26.07.2024

(86) International application number:
PCT/CN2024/107851

(87) International publication number:
WO 2025/055568 (20.03.2025 Gazette 2025/12)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 12.09.2023 CN 202311168836

(71) Applicant: Tongwei Solar (Meishan) Co., Ltd.
Meishan, Sichuan 620041 (CN)

(72) Inventors:
• ZHOU, Fan
  Meishan, Sichuan 620041 (CN)
• ZHOU, Hua
  Meishan, Sichuan 620041 (CN)

(74) Representative: Gill Jennings & Every LLP
The Broadgate Tower
20 Primrose Street
London EC2A 2ES (GB)

(54) **DIELECTRIC LAYER, PREPARATION METHOD, SOLAR CELL, AND PHOTOVOLTAIC MODULE**

(57) A dielectric layer, a preparation method, a solar cell, and a photovoltaic module. The dielectric layer is used for a solar cell and comprises an aluminum oxynitride layer containing hydrogen, and the nitrogen content of the dielectric layer is higher than 4 wt% and the hydrogen content thereof is higher than 4 wt%.

FIG. 2

EP 4 658 030 A1

**Description**

CROSS-REFERENCE TO RELATED APPLICATIONS

This application claims priority to Chinese Patent Application No. CN2023111688368, filed on September 12, 2023 and entitled "DIELECTRIC LAYER, PREPARATION METHOD, SOLAR CELL, AND PHOTOVOLTAIC MODULE", which is incorporated herein by reference in its entirety.

TECHNICAL FIELD

The present application relates to the field of photovoltaic technology, and in particular, to a dielectric layer, a preparation method, a solar cell, and a photovoltaic module.

BACKGROUND

In solar cells, photogenerated carriers may migrate to interfaces of the solar cells and recombine, resulting in losses instead of being collected by electrodes, which consequently leads to a decrease in the photoelectric conversion efficiency of the solar cells. In conventional technologies, passivation structures are provided in the solar cells to passivate surfaces of the solar cells to reduce the recombination of the photogenerated carriers on the surfaces of the solar cells. Some passivation structures exhibit poor continuity at the interfaces between films/layers and high interface defect densities, making it difficult to ensure the passivation effects. Moreover, the above-mentioned passivation structures are generally unable to enhance the refractive index, which is unfavorable for the further improvement of the photoelectric conversion efficiency of the solar cells.

SUMMARY

A dielectric layer, a preparation method, a solar cell, and a photovoltaic module are provided according to various embodiments of the present application.

In a first aspect, the present application provides a dielectric layer for a solar cell. The dielectric layer includes an aluminum oxynitride layer containing hydrogen. The dielectric layer has a nitrogen content greater than 4 wt% and a hydrogen content greater than 4 wt%.

In some embodiments, the dielectric layer includes the aluminum oxynitride layer.

In some embodiments, the dielectric layer includes a first dielectric layer and a second dielectric layer arranged stacked.

In some embodiments, the first dielectric layer is the aluminum oxynitride layer.

In some embodiments, the second dielectric layer includes any one of an aluminum oxide layer, a gallium oxide layer, a titanium dioxide layer, a zirconium dioxide layer, or a tantalum pentoxide layer.

In some embodiments, the second dielectric layer is grown on a substrate which is a P-type substrate or an N-type substrate, and the first dielectric layer is arranged on a surface of the second dielectric layer facing away from the P-type substrate or the N-type substrate.

In some embodiments, the second dielectric layer includes an aluminum oxide layer.

In some embodiments, the second dielectric layer has a thickness less than or equal to that of the first dielectric layer.

In some embodiments, the dielectric layer has a thickness less than 30 nm.

In some embodiments, the dielectric layer has a refractive index approximately ranging from 1.65 to 2.10.

In some embodiments, the dielectric layer has a roughness approximately ranging from 0.15 nm to 0.3 nm.

In some embodiments, the P-type substrate includes any one of a P-type silicon wafer, a P-type epitaxially grown doped layer, or a P-type diffusion layer.

In some embodiments, the N-type substrate includes an N-type silicon wafer.

In a second aspect, the present application provides a preparation method for a dielectric layer. The dielectric layer is the dielectric layer as described in the first aspect. The preparation method includes the following steps:

chemical adsorption: sequentially providing an aluminum source and an oxygen source, which are chemically adsorbed onto the surface of the P-type substrate or the N-type substrate, thereby completing one growth cycle, and repeating the growth cycle $x$ times to deposit the dielectric layer, wherein a nitrogen source is provided in at least 10 times of the $x$ times of the growth cycle, such that the dielectric layer has a nitrogen content greater than 4 wt% and a hydrogen content greater than 4 wt%; and
standing: allowing the dielectric layer to stand in an inert atmosphere at a temperature of 520°C to 600°C for a time of 10 min to 40 min.

In some embodiments, the dielectric layer includes a first dielectric layer and a second dielectric layer. The chemical adsorption includes the following steps:

sequentially providing the aluminum source and the oxygen source, which are chemically adsorbed onto the surface of the P-type substrate or the N-type substrate, thereby completing one growth cycle, and repeating the growth cycle y times to deposit the second dielectric layer, where y is greater than 0; and
sequentially providing the aluminum source and the oxygen source, which are chemically adsorbed onto a surface of the second dielectric layer facing away from the P-type substrate or the N-type substrate, thereby completing one growth cycle, and repeating the growth cycle z times to deposit the first dielectric layer, wherein the nitrogen source is provided in at least 10 times of the z times of the growth cycle.

In some embodiments, the standing includes the following step: allowing the first dielectric layer and the second dielectric layer to stand in an inert atmosphere at a temperature of approximately 520°C to 600°C for a time of approximately 10 min to 40 min.

In some embodiments, y is less than or equal to $z$.

In some embodiments, in the step of depositing the second dielectric layer, a temperature of each growth cycle is approximately 250°C to 400°C.

In some embodiments, in the step of depositing the first dielectric layer, a temperature of each growth cycle is approximately 250°C to 400°C.

In some embodiments, the aluminum source, the oxygen source, and the nitrogen source are each provided at a gas flow rate of approximately 20 sccm to 100 sccm.

In some embodiments, the aluminum source is provided for a time of approximately 8 s to 12 s, the oxygen source is provided for a time of approximately 8 s to 12 s, and the nitrogen source is provided for a time of approximately 15 s to 25 s.

In some embodiments, the aluminum source includes one of or a mixture of more of $Al(CH_3)_3$, $AlCl_3$, $Al(CH_3)_2Cl$, and $(CH_3)_2(C_2H_5)N:AlH_3$.

In some embodiments, the oxygen source includes one of or a mixture of more of $H_2O$, $O_2$, $O_3$, $N_2O$, and $CO_2$.

In some embodiments, the nitrogen source includes one of or a mixture of more of $N_2O$ and $NH_3$.

In a third aspect, the present application discloses a solar cell. The solar cell includes the dielectric layer as described in the first aspect. The solar cell also includes a protective layer stacked on a surface of the dielectric layer facing away from the P-type substrate or the N-type substrate.

In some embodiments, the protective layer has a thickness greater than or equal to 50 nm.

In some embodiments, a sum of thicknesses of the dielectric layer and the protective layer is approximately 75 nm to 85 nm.

In some embodiments, an effective refractive index of the dielectric layer and the protective layer is approximately 1.85 to 2.20.

In some embodiments, a material of the protective layer includes one of or a combination of more of silicon nitride, silicon oxynitride, silicon oxide, and silicon carbide, and the protective layer has a hydrogen content greater than or equal to 1 wt%.

In some embodiments, the solar cell includes any one of a back-passivated solar cell, a passivated contact solar cell, an N-type back contact solar cell, or a P-type back contact solar cell.

In some embodiments, the solar cell is the back-passivated solar cell, which includes:

a first P-type silicon wafer having a first side and a second side opposite to each other, with the first side being a light-incident side;
an N-type diffusion layer arranged on the first side;
a first passivation layer arranged on a side of the N-type diffusion layer facing away from the first P-type silicon wafer;
a first protective layer arranged on a side of the first passivation layer facing away from the first P-type silicon wafer;
a dielectric layer being an aluminum oxynitride layer and arranged on the second side;
a second protective layer arranged on a side of the aluminum oxynitride layer facing away from the first P-type silicon wafer; and
a first electrode structure including a first electrode and a second electrode, with the first electrode being in ohmic contact with the first P-type silicon wafer and the second electrode being in ohmic contact with the N-type diffusion layer.

In some embodiments, the solar cell is the back-passivated solar cell, which includes:

a first P-type silicon wafer having a first side and a second side opposite to each other, with the first side being a light-incident side;

an N-type diffusion layer arranged on the first side;

a first passivation layer arranged on a side of the N-type diffusion layer facing away from the first P-type silicon wafer;

a first protective layer arranged on a side of the first passivation layer facing away from the first P-type silicon wafer;

a dielectric layer including an aluminum oxide layer and an aluminum oxynitride layer sequentially stacked, with the aluminum oxide layer being arranged on the second side;

a second protective layer arranged on a side of the aluminum oxynitride layer facing away from the first P-type silicon wafer; and

a first electrode structure including a first electrode and a second electrode, with the first electrode being in ohmic contact with the first P-type silicon wafer and the second electrode being in ohmic contact with the N-type diffusion layer.

In some embodiments, the solar cell is the passivated contact solar cell, which includes:

a first N-type silicon wafer having a third side and a fourth side opposite to the third side, with the third side being a light-incident side;

a P-type diffusion layer arranged on the third side;

a dielectric layer being an aluminum oxynitride layer and arranged on a side of the P-type diffusion layer facing away from the first N-type silicon wafer;

a third protective layer arranged on a side of the aluminum oxynitride layer facing away from the first N-type silicon wafer;

a first tunneling oxide layer arranged on the fourth side;

a first doped polysilicon layer arranged on a side of the first tunneling oxide layer facing away from the first N-type silicon wafer;

a first anti-reflection layer arranged on a side of the first doped polysilicon layer facing away from the first N-type silicon wafer; and

a second electrode structure including a third electrode and a fourth electrode, with the third electrode being in ohmic contact with the P-type diffusion layer and the fourth electrode being in ohmic contact with the first doped polysilicon layer.

In some embodiments, the solar cell is the passivated contact solar cell, which includes:

a first N-type silicon wafer having a third side and a fourth side opposite to the third side, with the third side being a light-incident side;

a P-type diffusion layer arranged on the third side;

a dielectric layer including an aluminum oxide layer and an aluminum oxynitride layer sequentially stacked, with the aluminum oxide layer being arranged on a side of the P-type diffusion layer facing away from the first N-type silicon wafer;

a third protective layer arranged on a side of the aluminum oxynitride layer facing away from the first N-type silicon wafer;

a first tunneling oxide layer arranged on the fourth side;

a first doped polysilicon layer arranged on a side of the first tunneling oxide layer facing away from the first N-type silicon wafer;

a first anti-reflection layer arranged on a side of the first doped polysilicon layer facing away from the first N-type silicon wafer; and

a second electrode structure including a third electrode and a fourth electrode, with the third electrode being in ohmic contact with the P-type diffusion layer and the fourth electrode being in ohmic contact with the first doped polysilicon layer.

In some embodiments, the solar cell is the N-type back contact solar cell, which further includes:

a second N-type silicon wafer having a fifth side and a sixth side opposite to the fifth side, with the fifth side being a light-incident side;

a second passivation layer arranged on the fifth side;

a fourth protective layer arranged on a side of the second passivation layer facing away from the second N-type silicon wafer;

a second tunneling oxide layer including a first part and a second part, with the first part and the second part being arranged on the sixth side;

a second doped polysilicon layer including a P-type doped polysilicon layer and an N-type doped polysilicon layer, with the P-type doped polysilicon layer being arranged on a side of the first part facing away from the second N-type silicon wafer and the N-type doped polysilicon layer being arranged on a side of the second part facing away from the second N-type silicon wafer;

a dielectric layer being an aluminum oxynitride layer and including a third part, a fourth part, and a fifth part, with the third part being arranged on a side of the P-type doped polysilicon layer facing away from the second N-type silicon wafer, the fourth part being arranged on the sixth side and between the P-type doped polysilicon layer and the N-type doped polysilicon layer, and the fifth part being arranged on a side of the N-type doped polysilicon layer facing away from the second N-type silicon wafer;

a fifth protective layer arranged on sides of the third part, the fourth part, and the fifth part facing away from the second N-type silicon wafer; and

a third electrode structure including a fifth electrode and a sixth electrode, with the fifth electrode being in ohmic contact with the P-type doped polysilicon layer and the sixth electrode being in ohmic contact with the N-type doped polysilicon layer.

In some embodiments, the solar cell is the N-type back contact solar cell, which includes:

a second N-type silicon wafer having a fifth side and a sixth side opposite to the fifth side, with the fifth side being a light-incident side;

a second passivation layer arranged on the fifth side;

a fourth protective layer arranged on a side of the second passivation layer facing away from the second N-type silicon wafer;

a second tunneling oxide layer including a first part and a second part, with the first part and the second part being arranged on the sixth side;

a second doped polysilicon layer including a P-type doped polysilicon layer and an N-type doped polysilicon layer, with the P-type doped polysilicon layer being arranged on a side of the first part facing away from the second N-type silicon wafer and the N-type doped polysilicon layer being arranged on a side of the second part facing away from the second N-type silicon wafer;

a dielectric layer including a third part, a fourth part, and a fifth part, where

the third part includes a first aluminum oxide layer and a first aluminum oxynitride layer sequentially stacked, with the first aluminum oxide layer being arranged on a side of the P-type doped polysilicon layer facing away from the second N-type silicon wafer,

the fourth part includes a second aluminum oxide layer and a second aluminum oxynitride layer sequentially stacked, with the second aluminum oxide layer being arranged on the sixth side and between the P-type doped polysilicon layer and the N-type doped polysilicon layer, and

the fifth part includes a third aluminum oxide layer and a third aluminum oxynitride layer sequentially stacked, with the third aluminum oxide layer being arranged on a side of the N-type doped polysilicon layer facing away from the second N-type silicon wafer; and

a fifth protective layer arranged on sides of the first aluminum oxynitride layer, the second aluminum oxynitride layer, and the third aluminum oxynitride layer facing away from the second N-type silicon wafer; and

a third electrode structure including a fifth electrode and a sixth electrode, with the fifth electrode being in ohmic contact with the P-type doped polysilicon layer and the sixth electrode being in ohmic contact with the N-type doped polysilicon layer.

In some embodiments, the solar cell is the P-type back contact solar cell, which includes:

a second P-type silicon wafer having a seventh side and an eighth side opposite to the seventh side, with the seventh side being a light-incident side;

a third passivation layer arranged on the seventh side;

a sixth protective layer arranged on a side of the third passivation layer facing away from the second P-type silicon wafer;

a third tunneling oxide layer arranged on the eighth side;

an N-type doped polysilicon layer arranged on a side of the third tunneling oxide layer facing away from the second P-type silicon wafer;

a dielectric layer being an aluminum oxynitride layer and including a sixth part and a seventh part, with the sixth part being arranged on the eighth side and the seventh part being arranged on a side of the N-type doped polysilicon layer facing away from the second P-type silicon wafer;

a seventh protective layer arranged on sides of the sixth part and the seventh part facing away from the second N-type silicon wafer; and

a fourth electrode structure including a seventh electrode and an eighth electrode, with the seventh electrode being in ohmic contact with the second P-type silicon wafer and the eighth electrode being in ohmic contact with the N-type doped polysilicon layer.

In some embodiments, the solar cell is the P-type back contact solar cell, which includes:

a second P-type silicon wafer having a seventh side and an eighth side opposite to the seventh side, with the seventh side being a light-incident side;

a third passivation layer arranged on the seventh side;

a sixth protective layer arranged on a side of the third passivation layer facing away from the second P-type silicon wafer;

a third tunneling oxide layer arranged on the eighth side;

an N-type doped polysilicon layer arranged on a side of the third tunneling oxide layer facing away from the second P-type silicon wafer;

a dielectric layer including a sixth part and a seventh part, where

the sixth part includes a fourth aluminum oxide layer and a fourth aluminum oxynitride layer sequentially stacked, with the fourth aluminum oxide layer being arranged on the eighth side, and

the seventh part includes a fifth aluminum oxide layer and a fifth aluminum oxynitride layer sequentially stacked, with the fifth aluminum oxide layer arranged on a side of the N-type doped polysilicon layer facing away from the second P-type silicon wafer;

a seventh protective layer arranged on sides of the fourth aluminum oxynitride layer and the fifth aluminum oxynitride layer facing away from the second N-type silicon wafer; and

a fourth electrode structure including a seventh electrode and an eighth electrode, with the seventh electrode being in ohmic contact with the second P-type silicon wafer and the eighth electrode being in ohmic contact with the N-type doped polysilicon layer.

In a fourth aspect, embodiments of the present application further provide a photovoltaic module, including the solar cell as described in the third aspect.

Details of one or more embodiments of the present application are provided in the accompanying drawings and descriptions below. Other features, objectives, and advantages of the present application become apparent from the specification, the accompanying drawings, and the claims

BRIEF DESCRIPTION OF THE DRAWINGS

To describe the technical solutions in the embodiments of the present application or the conventional technologies more clearly, the following briefly introduces the accompanying drawings required for describing the embodiments or the conventional technologies. Apparently, the accompanying drawings in the following descriptions show merely some embodiments of the present application, and those of ordinary skill in the art may still derive other accompanying drawings from the disclosed accompanying drawings without creative efforts.

FIG. 1 is a schematic view of a preparation method for a dielectric layer disclosed in an embodiment of the present application;

FIG. 2 is a schematic structural view of a back-passivated solar cell disclosed in an embodiment of the present application;

FIG. 3 is a schematic structural view of another back-passivated solar cell disclosed in an embodiment of the present application;

FIG. 4 is a schematic structural view of a passivated contact solar cell disclosed in an embodiment of the present application;

FIG. 5 is a schematic structural view of another passivated contact solar cell disclosed in an embodiment of the present application;

FIG. 6 is a schematic structural view of an N-type back contact solar cell disclosed in an embodiment of the present application;

FIG. 7 is a schematic structural view of another N-type back contact solar cell disclosed in an embodiment of the present application;

FIG. 8 is a schematic structural view of a P-type back contact solar cell disclosed in an embodiment of the present application; and

FIG. 9 is a schematic structural view of another P-type back contact solar cell disclosed in an embodiment of the present application.

Reference numerals: 100-back-passivated solar cell; 11-first P-type silicon wafer; 12-N-type diffusion layer; 13-first passivation layer; 14-first protective layer; 15-dielectric layer; 151-aluminum oxide layer; 152-aluminum oxynitride layer; 16-second protective layer; 171-first electrode; 172-second electrode;

200-passivated contact solar cell; 21-first N-type silicon wafer; 22-P-type diffusion layer; 23-dielectric layer; 231-aluminum oxide layer; 232-aluminum oxynitride layer; 24-third protective layer; 25-first tunneling oxide layer; 26-first doped polysilicon layer; 27-first anti-reflection layer; 281-third electrode; 282-fourth electrode;

300-N-type back contact solar cell; 31-second N-type silicon wafer; 32-second passivation layer; 33-fourth protective layer; 34-second tunneling oxide layer; 341-first part; 342-second part; 351-P-type doped polysilicon layer; 352-N-type doped polysilicon layer; 36-dielectric layer; 361-third part; 3611-first aluminum oxide layer; 3612-first aluminum oxynitride layer; 362-fourth part; 3621-second aluminum oxide layer; 3622-second aluminum oxynitride layer; 363-fifth part; 3631-third aluminum oxide layer; 3632-third aluminum oxynitride layer; 37-fifth protective layer; 381-fifth electrode; 382-sixth electrode;

400-P-type back contact solar cell; 41-second P-type silicon wafer; 42-third passivation layer; 43-sixth protective layer; 44-third tunneling oxide layer; 45-N-type doped polysilicon layer; 46-dielectric layer; 461-sixth part; 4611-fourth aluminum oxide layer; 4612-fourth aluminum oxynitride layer; 462-seventh part; 4621-fifth aluminum oxide layer; 4622-fifth aluminum oxynitride layer; 47-seventh protective layer; 481-seventh electrode; 482-eighth electrode.

DETAILED DESCRIPTION

Technical solutions in embodiments of the present application are clearly and completely described below in combination with accompanying drawings in the embodiments of the present application, and it is apparent that the described embodiments are merely a part rather all of the embodiments of the present application. All other embodiments obtained by those of ordinary skill in art without creative labor based on the embodiments of the present application shall fall within the scope of protection of the present application.

One requirement for solar cells to achieve high efficiency is the effective suppression of surface recombination and recombination losses. Passivation structures such as $SiO_x$ and $SiN_x$ used for back passivation of the solar cells are prone to inducing inversion layers, which leads to a significant decrease in short-circuit current density. In addition, interfaces between films/layers in conventional passivation structures exhibit poor continuity and high interface defect density $D_{it}$ (up to $10^{11}$ eV$^{-1}$cm$^{-2}$ to $10^{12}$ eV$^{-1}$cm$^{-2}$), making it difficult to ensure passivation effects. Moreover, the above-mentioned passivation structures are generally unable to enhance the refractive index, which is unfavorable for the further improvement of the photoelectric conversion efficiency of the solar cells.

In view of this, in a first aspect, the present application provides a dielectric layer for a solar cell. The dielectric layer includes an aluminum oxynitride layer containing hydrogen, and the dielectric layer has a nitrogen content greater than 4 wt% and a hydrogen content greater than 4 wt%. The dielectric layer includes the aluminum oxynitride layer, which has a high density of negative charges $Q_f$ ($10^{12}$ cm$^{-2}$ to $10^{13}$ cm$^{-2}$) and can eliminate the parasitic capacitance effect, thereby reducing the generation of parasitic currents and then reducing losses of short-circuit current density. Additionally, the high density of negative charges can facilitate the field-effect passivation and reduce a concentration of carriers near an interface of the solar cell, thereby reducing carrier recombination. The aluminum oxynitride layer exhibits an excellent growth property, which can reduce interface roughness, improve interface continuity, and reduce the distribution of dangling bonds. By controlling the element contents of the dielectric layer to cause the nitrogen content of the dielectric layer to be greater than 4 wt%, the ease of bonding between nitrogen and hydrogen allows for the introduction of more hydrogen atoms, so that the hydrogen content is maintained above 4 wt%, thereby providing sufficient hydrogen atoms for chemical passivation, saturating the dangling bonds on the surface of the substrate, reducing defect recombination centers, and lowering the interface defect density $D_{it}$ (which can be reduced to $10^{10}$ eV$^{-1}$cm$^{-2}$ to $10^{11}$ eV$^{-1}$cm$^{-2}$). An increase in the content of nitrogen element which has a large atomic radius can enhance the compactness of the aluminum oxynitride layer, thereby increasing the refractive index, improving the anti-reflection effect of the incident light side of the solar cell, and increasing the absorption of incident light.

When the nitrogen content in the dielectric layer is less than 4 wt%, the introduction of hydrogen elements decreases, resulting in a hydrogen content below 4 wt%. Consequently, insufficient hydrogen atoms enter an interface between the dielectric layer and a P-type substrate or an N-type substrate, which is unfavorable for passivating the dangling bonds and reducing the defect density.

Exemplarily, the nitrogen content and the hydrogen content may each be any point value within the above-mentioned range, including but not limited to 4 wt%, 5 wt%, 6 wt%, 7 wt%, 8 wt%, 9 wt%, 10 wt%, 11 wt%, 12 wt%, 13 wt%, 14 wt%, 15 wt%, 16 wt%, 17 wt%, 18 wt%, 19 wt%, 20 wt%, 30 wt%, 40 wt%, etc.

In some embodiments, the dielectric layer includes the aluminum oxynitride layer, which may be, for example, a single aluminum oxynitride layer. The aluminum oxynitride layer contains a high density of negative charges $Q_f$ ($10^{12}$ cm$^{-2}$ to $10^{13}$ cm$^{-2}$), which can reduce losses of short-circuit current density and reduce a concentration of minority carriers near the interface through the field-effect passivation, thereby improving the photoelectric conversion efficiency of the solar cell. The single aluminum oxynitride layer, due to the high content of nitrogen element and the compactness of the single-layer structure, exhibits an improved refractive index, making it superior for surface anti-reflection.

In some embodiments, the aluminum oxynitride layer may be combined with other layers with a high density of negative charges to further reduce the losses of the short-circuit current density and enhance the passivation effect.

In some embodiments, the dielectric layer includes a first dielectric layer and a second dielectric layer arranged stacked. The second dielectric layer includes any one of an aluminum oxide layer, a gallium oxide layer, a titanium dioxide layer, a zirconium dioxide layer, or a tantalum pentoxide layer. The aluminum oxide layer, the gallium oxide layer, the titanium dioxide layer, the zirconium dioxide layer, or the tantalum pentoxide layer all have a high density of negative charges $Q_f$, ranging from $10^{12}$ cm$^{-2}$ to $10^{13}$ cm$^{-2}$.

By reducing the roughness of the dielectric layer, interface dangling bonds can be reduced, thereby improving the passivation effect and reducing surface defects. In some embodiments, a roughness range of the dielectric layer is approximately 0.15 nm to 0.3 nm. The dielectric layer in the embodiments of the present application exhibits a low roughness, a good film continuity, and few interface dangling bonds, which can reduce the surface defect density of the P-type substrate or the N-type substrate. Exemplarily, the roughness range of the dielectric layer may be any point value within the above-mentioned range, including but not limited to 0.15 nm, 0.16 nm, 0.17 nm, 0.18 nm, 0.19 nm, 0.20 nm, 0.21 nm, 0.22 nm, 0.23 nm, 0.24 nm, 0.25 nm, 0.26 nm, 0.27 nm, 0.28 nm, 0.29 nm, 0.30 nm, etc.

To reduce the roughness of the dielectric layer, a layer with a lower roughness may be recombined with the aluminum oxynitride layer. When recombining layers of different materials, lattice mismatch may occur between the layers due to a certain difference in lattice constants between the different materials. At a junction between the two material layers, the material with a lower lattice constant may have some dangling bonds, leading to interface defects.

In some embodiments, the first dielectric layer is the aluminum oxynitride layer, and the second dielectric layer is an aluminum oxide layer. The lattice constants of aluminum oxide and aluminum oxynitride exhibit minor differences, resulting in minimal lattice distortion at the junction of the aluminum oxide layer and the aluminum oxynitride layer, thereby reducing the dangling bonds. Additionally, the aluminum oxide layer exhibits excellent growth and wettability on a surface of the P-type substrate or the N-type substrate, resulting in lower roughness and fewer interface dangling bonds at a contact surface between the composite dielectric layer and the P-type substrate or the N-type substrate, thereby significantly improving the interface passivation effect. Moreover, the aluminum oxide layer and the aluminum oxynitride layer complement each other well. Although the aluminum oxide layer has a lower interface roughness, the aluminum oxide layer contains fewer hydrogen atoms, resulting in insufficient chemical passivation capability. The aluminum oxynitride layer contains a large number of hydrogen atoms that may migrate to the dangling bonds for chemical passivation, saturating the remaining few dangling bonds. Therefore, the combination of the aluminum oxide layer and the aluminum oxynitride layer can produce a synergistic effect, significantly reducing the dangling bonds at the interface and significantly lowering the interface defect density.

Optionally, the aluminum oxynitride layer may be arranged on a surface of the P-type substrate or the N-type substrate, and the aluminum oxide layer may be arranged on a surface of the aluminum oxynitride layer facing away from the P-type substrate or the N-type substrate. Alternatively, the aluminum oxide layer may be arranged on a surface of the P-type substrate or the N-type substrate, and the aluminum oxynitride layer may be arranged on a surface of the aluminum oxide layer facing away from the P-type substrate or the N-type substrate. The present application does not limit a stacking manner of the aluminum oxynitride layer and the aluminum oxide layer.

In some embodiments, the aluminum oxide layer may be arranged on a surface of the P-type substrate or the N-type substrate, and the aluminum oxynitride layer may be arranged on a surface of the aluminum oxide layer facing away from the P-type substrate or the N-type substrate. Stacking the aluminum oxide layer adjacent to the surface of the P-type substrate or the N-type substrate allows a layer with a lower roughness to directly contact the P-type substrate or the N-type substrate, resulting in a better passivation effect.

Taking the P-type substrate as an example (an interrelationship and interaction between the N-type substrate and the dielectric layer may also be deduced in a similar manner for the P-type substrate), in the solar cell, the dielectric layer is typically arranged between a protective layer (e.g., a silicon nitride layer) and the P-type substrate (typically a silicon wafer). To reduce the reflectivity of the light-incident side as much as possible, better utilize the interference effect of light, and improve the absorption effect on incident light by the solar cell as much as possible, the refractive index of the dielectric layer needs to fall between the refractive indexes of the protective layer and the P-type substrate. The refractive index of the silicon nitride layer is approximately 2.10, while the refractive index of the P-type substrate is approximately 3.42. The refractive index of the dielectric layer may be $\sqrt{2.1} * \sqrt{3.42} = 2.68$, and it is preferable for the refractive index of the dielectric layer to be as close to 2.68 as possible. In the embodiments of the present application, the refractive index of the dielectric layer ranges approximately from 1.65 to 2.10.

Exemplarily, the refractive index of the dielectric layer may be any point value within the above-mentioned range, such as 1.65, 1.68, 1.70, 1.72, 1.75, 1.77, 1.80, 1.83, 1.85, 1.87, 1.88, 1.89, 1.90, 1.91, 1.92, 1.93, 1.94, 1.95, 1.96, 1.96, 1.97, 1.98, 1.99, 2.00, 2.02, 2.04, 2.06, 2.08, 2.10, etc.

Further, in the solar cell, the dielectric layer and the protective layer such as the silicon nitride layer are arranged between the P-type substrate (typically a silicon wafer) and a photovoltaic glass. To improve the absorption of the incident light by the solar cell, the overall refractive index of the dielectric layer and the protective layer such as the silicon nitride layer need to meet certain requirements. For instance, the overall refractive index of the dielectric layer and the protective layer needs to fall between the refractive index of the photovoltaic glass (approximately 1.49) and the refractive index of the silicon wafer (approximately 3.42). The overall refractive index of the dielectric layer and the protective layer may be $\sqrt{1.49} * \sqrt{3.42} = 2.26$ . When the refractive index of the dielectric layer falls between 1.65 and 2.10, deviating significantly from the refractive index of 2.26, a thinner thickness may be set to increase the refractive index of the dielectric layer as much as possible. In some embodiments, the total thickness of the dielectric layer is less than 30 nm. Due to the relatively thin thickness, the refractive index of the dielectric layer can be enhanced, thereby bringing the overall refractive index of the dielectric layer and the protective layer closer to 2.26, which facilitates the absorption of the incident light by the solar cell.

In some embodiments, the thickness of the aluminum oxide layer is less than or equal to that of the aluminum oxynitride layer. Due to the high content of nitrogen element and high compactness of the aluminum oxynitride layer, the refractive index of the aluminum oxynitride layer is higher than that of the aluminum oxide layer. Therefore, to bring the refractive index of the composite dielectric layer closer to the refractive index of 2.26, a thicker aluminum oxynitride layer needs to be arranged compared to the aluminum oxide layer, which results in low reflectivity of the incident light, thereby facilitating incident light absorption and thus enhancing the photoelectric conversion efficiency. Additionally, the hydrogen atoms can more easily enter an interface between the aluminum oxide layer and the P-type substrate, thereby achieving better chemical passivation on the interface. When the aluminum oxide layer is thicker than the aluminum oxynitride layer, the aluminum oxide layer with a lower refractive index is thicker, thereby further reducing the refractive index of the composite dielectric layer, potentially increasing the reflectivity of the light-incident side of the solar cell, which is detrimental to the absorption of the incident light from the front side and reduces the photoelectric conversion efficiency. Additionally, an excessively thick aluminum oxide layer may hinder the entrance of the hydrogen atoms to the interface between the aluminum oxide layer and the P-type substrate, making it difficult to achieve chemical passivation on the interface.

In a second aspect, the present application provides a preparation method for the dielectric layer as described in the first aspect, which may be prepared using a method of atomic layer deposition (ALD), plasma enhanced atomic layer deposition (PEALD), or metal-organic chemical vapor deposition (MOCVD).Taking the method of ALD or PEALD as an example, by introducing precursors into a reactor to a surface of a substrate for deposition, chemical adsorption may occur on the surface to achieve film deposition. Each growth cycle completes deposition of one atomic layer, and a plurality of growth cycles result in the deposition of the dielectric layer.

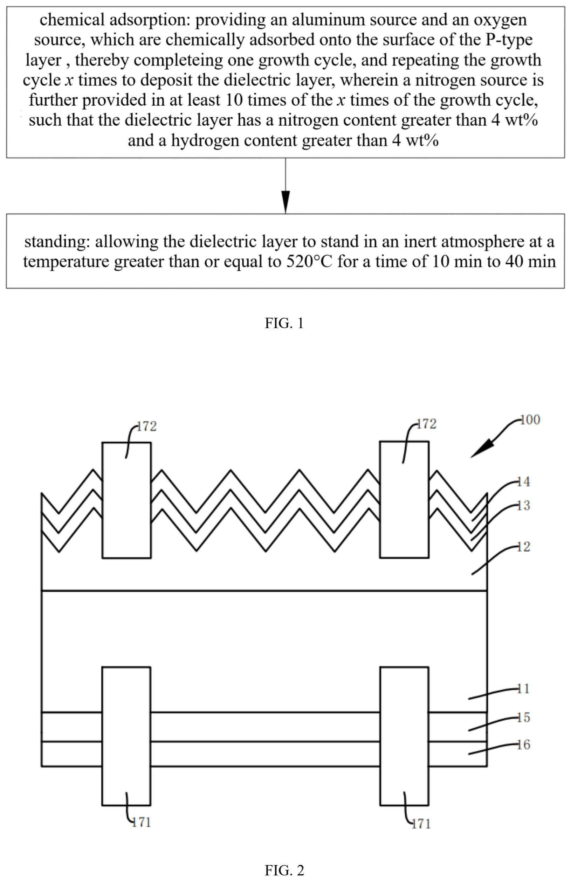

Referring to FIG. 1, when the dielectric layer is a single aluminum oxynitride layer, the preparation method includes the following steps: chemical adsorption: providing an aluminum source and an oxygen source, which are chemically adsorbed onto a surface of a P-type substrate or a N-type substrate, thereby completing one growth cycle, and repeating the growth cycle $x$ times to deposit the dielectric layer, wherein a nitrogen source is provided in at least 10 times of the $x$ times of the growth cycle, such that the dielectric layer has a nitrogen content greater than 4 wt% and a hydrogen content greater than 4 wt%; and standing: allowing the dielectric layer to stand in an inert atmosphere at a temperature of 520°C to 600°C for a time of 10 min to 40 min.

To better control the content of nitrogen element during the deposition of the aluminum oxynitride layer, the present application does not provide the nitrogen source as a gas source for every growth cycle; instead, the present application selectively introduces the nitrogen source. That is, some growth cycles involve only the introduction of the aluminum source and the oxygen source, while others involve the introduction of the aluminum source, the oxygen source, and the nitrogen source. To ensure that the nitrogen content is greater than 4 wt% and the hydrogen content is greater than 4 wt%, it is ensured that the nitrogen source is additionally provided in at least 10 of the total $x$ growth cycles. That is, it should be understood that the total number of cycles $x$ is greater than or equal to 10, and $x$ may be 10, 15, 20, 22, 25, 27, 30, 32, 35, 40, 45, 50, 55, 60, 70, 80, 100, 120, 150, etc.

In some embodiments, the aluminum source may include one or more of $Al(CH_3)_3$, $AlCl_3$, $Al(CH_3)_2Cl$, and $(CH_3)_2(C_2H_5)N{:}AlH_3$. The oxygen source may include one or more of $H_2O$, $O_2$, $O_3$, $N_2O$, and $CO_2$. The nitrogen source may include one or more of $N_2O$ and $NH_3$. The above-mentioned precursor materials exhibit high volatility, thermal stability, reactivity, and safety, thereby achieving mutual chemical reactions under heating or ionization conditions. During the growth cycle, the materials not only can react with surface groups generated in the previous growth cycle, but also can generate new reactive groups for a next precursor reaction.

Taking the ALD method as an example, the ALD method requires that the aluminum source, the oxygen source, and the nitrogen source can react with each other under heating conditions, with $Al(CH_3)_3$, $H_2O$, and $NH_3$ selectable. For instance, the preparation process is as follows. $H_2O$ is first introduced into the reactor to allow -OH to be adsorbed onto the surface of the P-type substrate. $Al(CH_3)_3$ is then introduced and subjected to a saturated chemically adsorption by -OH, generating unsaturated aluminum-containing functional groups, and excess $Al(CH_3)_3$ and impurity gases are evacuated. $H_2O$ is then introduced again to react with the unsaturated aluminum-containing functional groups, binding oxygen to aluminum to generate new functional groups, and excess $H_2O$ and impurities are evacuated. During the growth cycles where nitrogen source introduction is required, $NH_3$ is introduced for chemical adsorption until the above-mentioned functional groups are saturated, thereby ensuring that aluminum atoms are fully linked to nitrogen atoms, while the nitrogen atoms are linked to a large number of hydrogen atoms. Then excess $NH_3$ and impurities such as generated $CH_4$ are evacuated.

In some embodiments, when the dielectric layer includes the second dielectric layer and the first dielectric layer stacked sequentially, with the second dielectric layer being the aluminum oxide layer and the first dielectric layer being the aluminum oxynitride layer, the preparation method includes the following steps:

sequentially providing the aluminum source and the oxygen source, which are chemically adsorbed on the surface of the P-type substrate or the N-type substrate, thereby completing one growth cycle, and repeating the growth cycle y times to deposit the second dielectric layer, where y is greater than 0; and

sequentially providing the aluminum source and the oxygen source, which are chemically adsorbed on a surface of the second dielectric layer facing away from the P-type substrate or the N-type substrate, thereby completing one growth cycle, and repeating the growth cycle z times to deposit the first dielectric layer, wherein the nitrogen source is provided in at least 3 times of the z times of the growth cycle. It should be understood that to ensure that the nitrogen content is greater than 4 wt% and the hydrogen content is greater than 4 wt%, it is ensured that the nitrogen source is additionally provided in at least 10 of the total z growth cycles. That is, it should be understood that the total number of cycles $x$ is greater than or equal to 10, and $x$ may be 11, 15, 20, 22, 25, 27, 30, 32, 35, 40, 45, 50, 55, 60, 70, 80, 100, 120, 150, etc.

Using the ALD method as an example to describe the preparation method for the first dielectric layer and the second dielectric layer, similarly, in the deposition of the aluminum oxide layer by the ALD method, the aluminum source and the oxygen source are also required to react with each other under heating conditions. Therefore, $Al(CH_3)_3$ and $H_2O$, which can react with each other, may be selected.

For instance, the preparation process is as follows. First, the deposition of the aluminum oxide layer is performed. $H_2O$ is first introduced into the reactor to allow -OH to be adsorbed onto the surface of the P-type substrate or the N-type substrate. $Al(CH_3)_3$ is then introduced and subjected to a saturated chemical adsorption by -OH on the surface of the P-type substrate or the N-type substrate, generating unsaturated aluminum-containing functional groups, and excess $Al(CH_3)_3$ and impurity gases are evacuated. $H_2O$ is then introduced again and subjected to a saturated chemical adsorption, thereby linking oxygen atoms to aluminum atoms while generating new -OH to provide linkage sites for the deposition of the aluminum oxynitride layer. The excess $H_2O$ and impurities are evacuated to complete one growth cycle. The growth cycle is repeated y times to deposit the aluminum oxide layer. Exemplarily, $y$ may be 1, 2, 3, 4, 5, 6, 7, 8, 9, 10, 11, 12, 13, 14, 15, 20, 30, 40, 50, 60, 70, 80, 100, 150, etc.

Subsequently, the deposition of the aluminum oxynitride layer is performed. $Al(CH_3)_3$ is first introduced into the reactor and subjected to a saturated chemical adsorption by a large quantity of -OH newly generated on a surface of the aluminum oxide layer, generating unsaturated aluminum-containing functional groups, and the excess $Al(CH_3)_3$ and impurity gases are evacuated. $H_2O$ is then introduced again and subjected to a chemical adsorption by the unsaturated functional groups until saturation, thereby linking oxygen atoms to aluminum atoms, and the excess $H_2O$ and impurities are evacuated. During the growth cycles where nitrogen source introduction is required, $NH_3$ is introduced for chemical adsorption until saturation, generating $-NH_2$ that replaces $-CH_3$ to link with Al or that directly link with Al, while also linking with H. The excess $NH_3$ and impurities are evacuated, thereby completing one growth cycle.

In some embodiments, the deposition of the single aluminum oxynitride layer or the composite dielectric layer of the aluminum oxide layer and the aluminum oxynitride layer may also employ the PEALD method. Through ionization assistance, a lower reaction temperature may be selected, resulting in lower energy consumption. Correspondingly, the oxygen source may be replaced with $O_2$. Compared to $H_2O$, $O_2$ has two following advantages. First, reaction conditions for $O_2$ are less stringent, the PEALD method does not require mutual reactions among the aluminum source, the oxygen source, and the nitrogen source, and chemical adsorption of all three can be achieved through ionization. Secondly, $O_2$ facilitates the maintenance of the reaction device. Although $H_2O$ is stable, it is difficult to be completely evacuated after $H_2O$ adsorption, and the residual $H_2O$ may react with subsequently introduced process gases to generate by-products, causing corrosion on one hand and increasing the deposition and accumulation of films on reaction apparatuses such as a quartz tube on the other hand. When the film reaches a certain thickness, the film may detach, affecting the process and increasing the maintenance frequency and difficulty of the reaction device. In contrast, when $O_2$ is used, oxygen ions are generated through ionization, and the oxygen ions have a short lifespan and may become inactive within a certain period of time even if the oxygen ions cannot be completely evacuated, thereby reducing side reactions and minimizing the losses of the reaction apparatus.

Taking the P-type substrate as an example (the N-type substrate may be deduced similarly to the P-type substrate), in some embodiments, after the preparation of the dielectric layer is completed, the dielectric layer needs to be left to stand under an inert atmosphere at a temperature of approximately 520°C to 600°C for a time of approximately 10 min to 40 min. The hydrogen atoms in the single dielectric layer can be allowed to migrate to an interface between the P-type substrate and the aluminum oxynitride layer, or the hydrogen atoms in the composite dielectric layer are allowed to migrate to interfaces between the P-type substrate and the aluminum oxide layer and between the aluminum oxide layer and the aluminum oxynitride layer, thereby chemically passivating the dangling bonds between the interfaces. When the standing temperature is relatively low, insufficient activity and weak mobility of the hydrogen atoms may be resulted in. Additionally, the standing step can also allow residual methyl ($CH_3$) in the composite dielectric layer to be decomposed from the dielectric layer, thereby achieving further bonding among aluminum, oxygen, and nitrogen atoms, and increasing the compactness of the dielectric layer and improving the refractive index. Exemplarily, the inert atmosphere may be nitrogen gas, helium gas, etc. The standing temperature may be any point value within the above-mentioned range, including but not limited to 520°C, 530°C, 540°C, 550°C, 560°C, 570°C, 580°C, 590°C, 600°C, etc. The standing time may be any point value within the above-mentioned range, including but not limited to 10 min, 15 min, 20 min, 25 min, 30 min, 35 min, 40 min, etc.

In some embodiments, to ensure that the composite dielectric layer has a higher refractive index and to minimize a distance that the hydrogen atoms in the aluminum oxynitride layer and the aluminum oxide layer migrate to the interface with the P-type substrate, the thickness of the aluminum oxide layer needs to be less than or equal to that of the aluminum oxynitride layer. Since the thickness of each growth cycle is that of a single atomic layer, the total number y of growth cycles for the aluminum oxide layer needs to be controlled to be less than or equal to the total number z of growth cycles for the aluminum oxynitride layer.

In some embodiments, the temperature for each growth cycle is approximately 250°C to 400°C. The activity of the precursors during each growth cycle can be effectively maintained, the progress of chemical adsorption and reactions can be ensured, and the dielectric layer can meet the requirements for growth thickness and compactness. Moreover, the structural stability of the precursors during each growth cycle can be maintained, thereby preventing precursor decomposition or the breaking of chemical bonds in the precursors that have undergone the chemical adsorption, which may lead to desorption and detachment of the precursors from the P-type substrate, affecting the compactness of the dielectric layer, and resulting in a thinner dielectric layer. When the temperature of each growth cycle is relatively low, insufficient activity and low reactivity of the precursors may be resulted in. When the temperature of each growth cycle is relatively high, precursor decomposition may be caused, affecting the adsorption and reaction progress.

Exemplarily, the temperature of each growth cycle may be any point value within the above-mentioned range, including but not limited to 250°C, 260°C, 270°C, 280°C, 290°C, 300°C, 310°C, 320°C, 330°C, 340°C, 350°C, 360°C, 370°C, 380°C, 390°C, 400°C, etc.

In some embodiments, gas flow rates of the aluminum source, the oxygen source, and the nitrogen source are approximately 20 sccm to 100 sccm. The aluminum source is provided for a time of approximately 8 s to 12 s, the oxygen source is provided for a time of approximately 8 s to 12 s, and the nitrogen source is provided for a time of approximately 15 s to 25 s. The above-mentioned introduction times of various gases in each cycle are each a time that ensures that gas molecules can fully cover the surface of the silicon wafer. Both the above-mentioned flow rates and providing times influence the number of reaction sites newly generated by the precursors, and controlling the times and flow rates can ensure that precursor molecules can be chemically adsorbed onto all reaction sites on the surface. The providing time of the nitrogen source is controlled within the range of 15 s to 25 s. On one hand, since the nitrogen source is introduced fewer times compared to the oxygen source and the aluminum source, setting a longer providing time of the nitrogen source than those of the oxygen source and the aluminum source not only allows for sufficient chemical adsorption utilizing a smaller number of nitrogen sources, but also can introduce more nitrogen elements into the dielectric layer, thereby continuously introducing the hydrogen element and ensuring the contents of nitrogen element and hydrogen element. Exemplarily, the gas flow rates may be any point values within the above-mentioned ranges, including but not limited to 20 sccm, 30 sccm, 40 sccm, 50 sccm, 60 sccm, 70 sccm, 80 sccm, 90 sccm, 100 sccm, etc. The providing times of the aluminum source, the oxygen source, and the nitrogen source may be any point values within the above-mentioned ranges, such as 8 s, 9 s, 10 s, 11 s, 12 s, etc. The providing time of the nitrogen source may be 15 s, 16 s, 17 s, 18 s, 19 s, 20 s, 21 s, 22 s, 23 s, 24 s, 25 s, etc.

In some embodiments, evacuation is required after introducing the aluminum source, the oxygen source, and the nitrogen source to remove residual gases, excess precursors, and by-products such as $CH_4$, thereby reducing the impact on subsequent growth cycles. The evacuation time may range from 8 s to 12 s to ensure that excess gas molecules may be completely evacuated. Exemplarily, the evacuation time may be any point value within the above-mentioned range, including but not limited to 8 s, 9 s, 10 s, 11 s, 12 s, etc.

In a third aspect, the present application provides a solar cell. The solar cell includes the dielectric layer as described in the first aspect. The solar cell also includes a protective layer stacked on a surface of the dielectric layer away from the P-type substrate or the N-type substrate.

A material of the above-mentioned protective layer includes one of or a combination of more of silicon nitride, silicon oxynitride, silicon oxide, and silicon carbide. A temperature and a time required for the deposition of the above-mentioned protective layer are similar to those required for standing of the above-mentioned dielectric layer. Therefore, in an industrial production process, after the deposition of the dielectric layer, the protective layer may be immediately prepared and the temperature and the time of the deposition of the protective layer may be controlled to allow the standing step of the dielectric layer to be completed while depositing the protective layer on the surface of the dielectric layer.

The solar cell includes a P-type substrate or an N-type substrate. The solar cell may be any one of a back-passivated solar cell, a passivated contact solar cell, or a back contact solar cell.

It should be noted that the dielectric layer in the present application is arranged adjacent to a surface of the P-type substrate or the N-type substrate of the solar cell for chemical passivation and field passivation of the surface of the P-type substrate or the N-type substrate, thereby effectively suppressing recombination losses at the surface of the P-type substrate or the N-type substrate and improving the photoelectric conversion efficiency.

In some embodiments, the P-type substrate includes any one of a P-type silicon wafer, a P-type epitaxially grown doped layer, or a P-type diffusion layer. The P-type silicon wafer refers to monocrystalline silicon doped with group III elements, which include but are not limited to boron, aluminum, gallium, etc. The P-type diffusion layer refers to a diffusion layer formed by diffusing the group III elements into an N-type silicon wafer, where the N-type silicon wafer refers to monocrystalline silicon doped with group V elements, including, but not limited to, nitrogen, phosphorus, arsenic, etc. The P-type epitaxially grown doped layer refers to one or more of a polysilicon layer, a silicon carbide layer, a silicon nitride layer, or a silicon oxide layer doped with the group III elements.

In some embodiments, the N-type substrate includes an N-type silicon wafer. It should be noted that the N-type substrate in embodiments of the present application does not include an N-type diffusion layer or an N-type epitaxially grown doped layer.

Exemplarily, the P-type silicon wafer may be monocrystalline silicon doped with a boron element, the P-type diffusion layer may be a diffusion layer with a high or low concentration of boron element diffused, and the P-type epitaxially grown doped layer may be a boron-doped polysilicon layer. The N-type silicon wafer may be monocrystalline silicon doped with phosphorus element.

Further, the surface of the P-type substrate or the N-type substrate refers to either a front side or a back side, where the front side refers to a light-incident side and the back side refers to a side opposite to the light-incident side. The dielectric layer may be arranged on only the front side or the back side, or arranged on both the front side and the back side. The dielectric layer in embodiments of the present application may be applied to front sides or back sides of various P-type substrates or N-type substrates in various solar cells, and can achieve effective field passivation and chemical passivation on the front sides or back sides of the various solar cells, thereby improving the refractive index of the front sides or back sides, and thus enhancing the anti-reflection effect. An arrangement position of the dielectric layer in the present application will be illustrated below in combination with specific schematic views.

Referring to FIG. 2, an embodiment of the present application provides a PERC solar cell 100 (Passivated Emitter and Rear Cell, a back-passivated solar cell).

When the dielectric layer is a single aluminum oxynitride layer, the back-passivated solar cell 100 includes:

a first P-type silicon wafer 11 having a first side and a second side opposite to each other, with the first side being a light-incident side;
an N-type diffusion layer 12 arranged on the first side;
a first passivation layer 13 arranged on a side of the N-type diffusion layer 12 facing away from the first P-type silicon wafer 11;
a first protective layer 14 arranged on a side of the first passivation layer 13 facing away from the first P-type silicon wafer 11;
a dielectric layer 15 being an aluminum oxynitride layer and arranged on the second side;
a second protective layer 16 arranged on a side of the aluminum oxynitride layer 15 facing away from the first P-type silicon wafer 11; and
a first electrode structure including a first electrode 171 and a second electrode 172, with the first electrode 171 being in ohmic contact with the first P-type silicon wafer 11 and the second electrode 172 being in ohmic contact with the N-type diffusion layer 12.

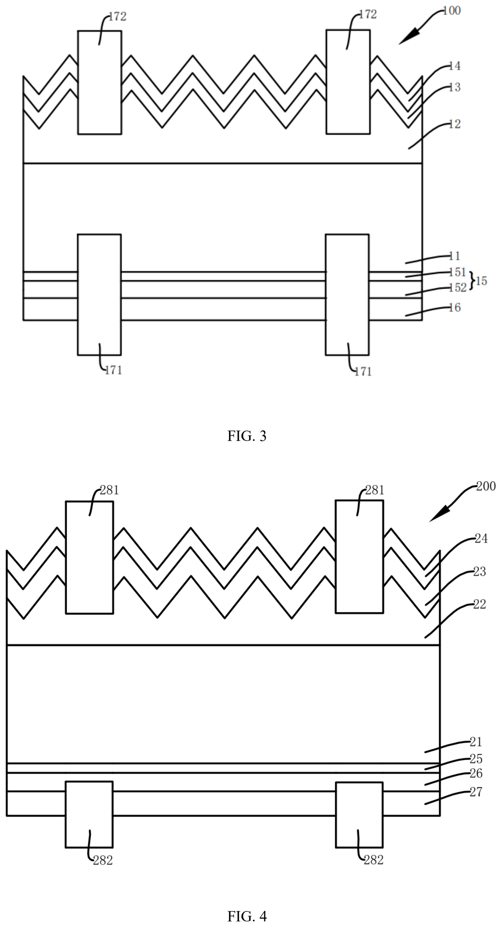

Referring to FIG. 3, when the dielectric layer is composed of an aluminum oxide layer and an aluminum oxynitride layer sequentially stacked, the back-passivated solar cell 100 includes:

a first P-type silicon wafer 11 having a first side and a second side opposite to each other, with the first side being a light-incident side;
an N-type diffusion layer 12 arranged on the first side;

a first passivation layer 13 arranged on a side of the N-type diffusion layer 12 facing away from the first P-type silicon wafer 11;

a first protective layer 14 arranged on a side of the first passivation layer 13 facing away from the first P-type silicon wafer 11;

a dielectric layer 15 including an aluminum oxide layer 151 and an aluminum oxynitride layer 152 sequentially stacked, with the aluminum oxide layer 151 being arranged on the second side;

a second protective layer 16 arranged on a side of the aluminum oxynitride layer 152 away from the first P-type silicon wafer 11; and

a first electrode structure including a first electrode 171 and a second electrode 172, with the first electrode 171 being in ohmic contact with the first P-type silicon wafer 11 and the second electrode 172 being in ohmic contact with the N-type diffusion layer 12.

Exemplarily, in the back-passivated solar cell, the first passivation layer 13 may be a silicon oxide layer; the first protective layer 14 may be a silicon nitride layer, a silicon oxynitride layer, etc.; and the second protective layer 16 may be a silicon nitride layer, a silicon oxynitride layer, etc.

Referring to FIG. 4, an embodiment of the present application provides a TOPCon solar cell 200 (Tunnel Oxide Passivating Contacts, a passivated contact solar cell).

When the dielectric layer is a single aluminum oxynitride layer, the passivated contact solar cell 200 includes:

a first N-type silicon wafer 21 having a third side and a fourth side opposite to the third side, with the third side being a light-incident side;

a P-type diffusion layer 22 arranged on the third side;

a dielectric layer 23 being an aluminum oxynitride layer, the aluminum oxynitride layer 23 being arranged on a side of the P-type diffusion layer 22 facing away from the first N-type silicon wafer 21;

a third protective layer 24 arranged on a side of the aluminum oxynitride layer 23 facing away from the first N-type silicon wafer 21;

a first tunneling oxide layer 25 arranged on the fourth side;

a first doped polysilicon layer 26 arranged on a side of the first tunneling oxide layer 25 facing away from the first N-type silicon wafer 21;

a first anti-reflection layer 27 arranged on a side of the first doped polysilicon layer 26 facing away from the first N-type silicon wafer 21; and

a second electrode structure including a third electrode 281 and a fourth electrode 282, with the third electrode 281 being in ohmic contact with the P-type diffusion layer 22 and the fourth electrode 282 being in ohmic contact with the first doped polysilicon layer 26.

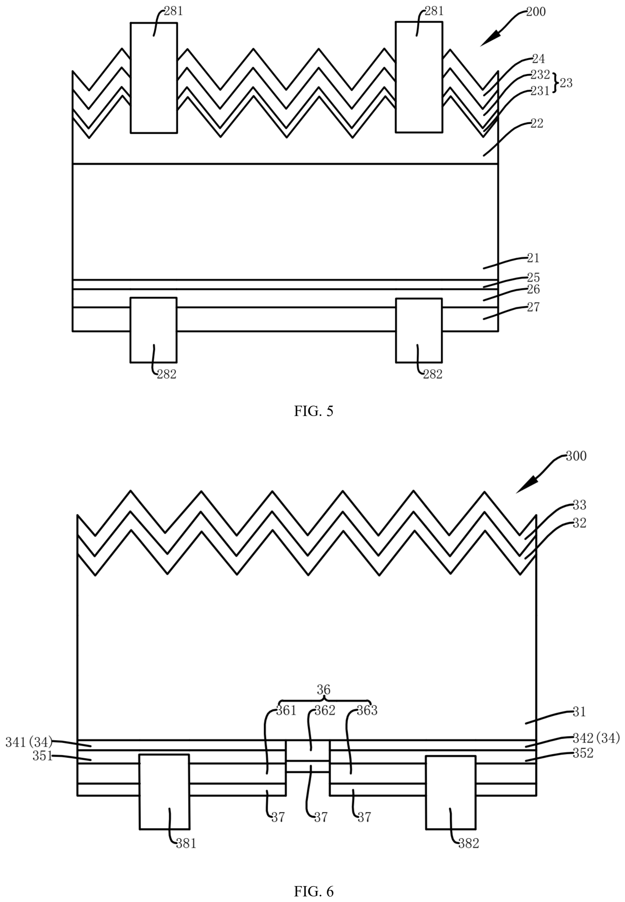

Referring to FIG. 5, when the dielectric layer is composed of an aluminum oxide layer and an aluminum oxynitride layer sequentially stacked, the passivated contact solar cell 200 includes:

a first N-type silicon wafer 21 having a third side and a fourth side opposite to the third side, with the third side being a light-incident side;

a P-type diffusion layer 22 arranged on the third side;

a dielectric layer 23 including an aluminum oxide layer 231 and an aluminum oxynitride layer 232 sequentially stacked, with the aluminum oxide layer 231 arranged on a side of the P-type diffusion layer 22 facing away from the first N-type silicon wafer 21;

a third protective layer 24 arranged on a side of the aluminum oxynitride layer 232 facing away from the first N-type silicon wafer 21;

a first tunneling oxide layer 25 arranged on the fourth side;

a first doped polysilicon layer 26 arranged on a side of the first tunneling oxide layer 25 facing away from the first N-type silicon wafer 21;

a first anti-reflection layer 27 arranged on a side of the first doped polysilicon layer 26 facing away from the first N-type silicon wafer 21; and

a second electrode structure including a third electrode 281 and a fourth electrode 282, with the third electrode 281 being in ohmic contact with the P-type diffusion layer 22 and the fourth electrode 282 being in ohmic contact with the first doped polysilicon layer 26.

Exemplarily, in the passivated contact solar cell, the third protective layer 24 may be a silicon nitride layer, a silicon oxynitride layer, etc.; and the first anti-reflection layer may be a silicon nitride layer, a silicon oxynitride layer, etc.

Referring to FIG. 6, the present application provides an N-type IBC solar cell 300 (Interdigitated back contact, an N-type back contact solar cell).

When the dielectric layer is a single aluminum oxynitride layer, the N-type back contact solar cell 300 includes:

a second N-type silicon wafer 31 having a fifth side and a sixth side opposite to the fifth side, with the fifth side being a light-incident side;

a second passivation layer 32 arranged on the fifth side;

a fourth protective layer 33 arranged on a side of the second passivation layer 32 facing away from the second N-type silicon wafer 31;

a second tunneling oxide layer 34 including a first part 341 and a second part 342, with the first part 341 and the second part 342 being arranged on the sixth side;

a second doped polysilicon layer including a P-type doped polysilicon layer 351 and an N-type doped polysilicon layer 352, with the P-type doped polysilicon layer 351 being arranged on a side of the first part 341 facing away from the second N-type silicon wafer 31 and the N-type doped polysilicon layer 352 being arranged on a side of the second part 342 facing away from the second N-type silicon wafer 31;

a dielectric layer 36 being an aluminum oxynitride layer and including a third part 361, a fourth part 362, and a fifth part 363, with the third part 361 being arranged on a side of the P-type doped polysilicon layer 351 facing away from the second N-type silicon wafer 31, the fourth part 362 being arranged on the sixth side and between the P-type doped polysilicon layer 351 and the N-type doped polysilicon layer 352, and the fifth part 363 being arranged on a side of the N-type doped polysilicon layer 352 facing away from the second N-type silicon wafer 31;

a fifth protective layer 37 arranged on sides of the third part 361, the fourth part 362, and the fifth part 363 facing away from the second N-type silicon wafer 31; and

a third electrode structure including a fifth electrode 381 and a sixth electrode 382, with the fifth electrode 381 being in ohmic contact with the P-type doped polysilicon layer 351 and the sixth electrode 382 being in ohmic contact with the N-type doped polysilicon layer 352.

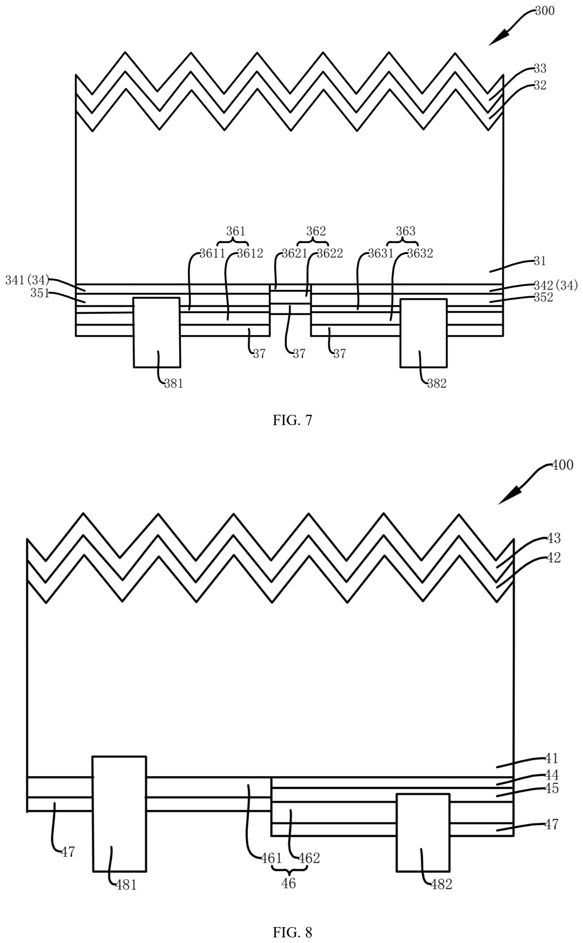

Referring to FIG. 7, when the dielectric layer is composed of an aluminum oxide layer and an aluminum oxynitride layer sequentially stacked, the N-type back contact solar cell 300 includes:

a second N-type silicon wafer 31 having a fifth side and a sixth side opposite to the fifth side, with the fifth side being a light-incident side;

a second passivation layer 32 arranged on the fifth side;

a fourth protective layer 33 arranged on a side of the second passivation layer 32 facing away from the second N-type silicon wafer 31;

a second tunneling oxide layer 34 including a first part 341 and a second part 342, with the first part 341 and a second part 342 being arranged on the sixth side;

a second doped polysilicon layer including a P-type doped polysilicon layer 351 and an N-type doped polysilicon layer 352, with the P-type doped polysilicon layer 351 being arranged on a side of the first part 341 facing away from the second N-type silicon wafer 31 and the N-type doped polysilicon layer 352 being arranged on a side of the second part 342 facing away from the second N-type silicon wafer 31;

a dielectric layer 36 including a third part 361, a fourth part 362, and a fifth part 363, where

the third part 361 includes a first aluminum oxide layer 3611 and a first aluminum oxynitride layer 3612 sequentially stacked, with the first aluminum oxide layer 3611 being arranged on a side of the P-type doped polysilicon layer 351 facing away from the second N-type silicon wafer 31;

the fourth part 362 includes a second aluminum oxide layer 3621 and a second aluminum oxynitride layer 3622 sequentially stacked, with the second aluminum oxide layer 3621 being arranged on the sixth side and between the P-type doped polysilicon layer 351 and the N-type doped polysilicon layer 352; and

the fifth part 363 includes a third aluminum oxide layer 3631 and a third aluminum oxynitride layer 3632 sequentially stacked, with the third aluminum oxide layer 3631 being arranged on a side of the N-type doped polysilicon layer 352 facing away from the second N-type silicon wafer 31; and

a fifth protective layer 37 arranged on sides of the first aluminum oxynitride layer 3612, the second aluminum oxynitride layer 3622, and the third aluminum oxynitride layer 3632 facing away from the second N-type silicon wafer 31; and

a third electrode structure including a fifth electrode 381 and a sixth electrode 382, with the fifth electrode 381 being in ohmic contact with the P-type doped polysilicon layer 351 and the sixth electrode 382 being in ohmic contact with the N-type doped polysilicon layer 352.

Exemplarily, in the N-type back contact solar cell, the second passivation layer 32 may be an aluminum oxynitride layer, an aluminum oxide layer, a silicon dioxide layer, etc.; the fourth protective layer 33 may be a silicon nitride layer, etc.;

and the fifth protective layer 37 may be a silicon nitride layer, etc.

Further, the second passivation layer 32 is optionally the aluminum oxynitride layer. When the second passivation layer 32 is the aluminum oxynitride layer, since the aluminum oxynitride layer has a high hydrogen content, the aluminum oxynitride layer has a better hydrogen passivation effect compared to silicon dioxide. Additionally, compared to the silicon dioxide, silicon oxynitride experiences less degradation in passivation quality under ultraviolet irradiation, and has superior uvioresistant stability, thereby allowing for better long-term stability of the solar cell. By arranging a film layer containing the aluminum oxynitride layer on both the fifth side and the sixth side of the second N-type silicon wafer, the passivation effects on both a front side and a back side of the N-type back contact solar cell are significantly enhanced, which is conducive to improving the photoelectric conversion efficiency.

Referring to FIG. 8, the present application provides a P-type IBC solar cell 400 (Interdigitated back contact, a P-type back contact solar cell).

When the dielectric layer is a single aluminum oxynitride layer, the P-type back contact solar cell 400 includes:

a second P-type silicon wafer 41 having a seventh side and an eighth side opposite to the seventh side, with the seventh side being a light-incident side;
a third passivation layer 42 arranged on the seventh side;
a sixth protective layer 43 arranged on a side of the third passivation layer 42 facing away from the second P-type silicon wafer 41;
a third tunneling oxide layer 44 arranged on the eighth side;
an N-type doped polysilicon layer 45 arranged on a side of the third tunneling oxide layer 44 facing away from the second P-type silicon wafer 41;
a dielectric layer 46 being an aluminum oxynitride layer and including a sixth part 461 and a seventh part 462, with the sixth part 461 being arranged on the eighth side and the seventh part 462 being arranged on a side of the N-type doped polysilicon layer 45 facing away from the second P-type silicon wafer 41;
a seventh protective layer 47 arranged on sides of the sixth part 461 and the seventh part 462 facing away from the second N-type silicon wafer 41; and
a fourth electrode structure including a seventh electrode 481 and an eighth electrode 482, with the seventh electrode 481 being in ohmic contact with the second P-type silicon wafer 41 and the eighth electrode 482 being in ohmic contact with the N-type doped polysilicon layer 45.

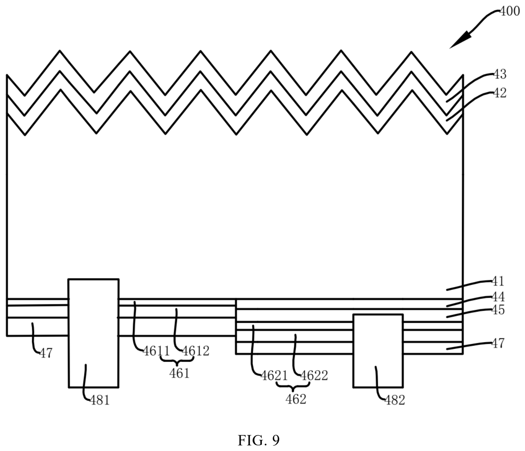

Referring to FIG. 9, when the dielectric layer is composed of an aluminum oxide layer and an aluminum oxynitride layer sequentially stacked, the P-type back contact solar cell 300 includes:

a second P-type silicon wafer 41 having a seventh side and an eighth side opposite to the seventh side, with the seventh side being a light-incident side;
a third passivation layer 42 arranged on the seventh side;
a sixth protective layer 43 arranged on a side of the third passivation layer 42 facing away from the second P-type silicon wafer 41;
a third tunneling oxide layer 44 arranged on the eighth side;
an N-type doped polysilicon layer 45 arranged on a side of the third tunneling oxide layer 44 facing away from the second P-type silicon wafer 41;
a dielectric layer 46 including a sixth part 461 and a seventh part 462, where
the sixth part 461 includes a fourth aluminum oxide layer 4611 and a fourth aluminum oxynitride layer 4612 sequentially stacked, with the fourth aluminum oxide layer 4611 being arranged on the eighth side; and
the seventh part 462 includes a fifth aluminum oxide layer 4621 and a fifth aluminum oxynitride layer 4622 sequentially stacked, with the fifth aluminum oxide layer 4621 being arranged on a side of the N-type doped polysilicon layer 45 facing away from the second P-type silicon wafer 41;
a seventh protective layer 47 arranged on sides of the fourth aluminum oxynitride layer 4612 and the fifth aluminum oxynitride layer 4622 facing away from the second N-type silicon wafer 41; and
a fourth electrode structure including a seventh electrode 481 and an eighth electrode 482, with the seventh electrode 481 being in ohmic contact with the second P-type silicon wafer 41 and the eighth electrode 482 being in ohmic contact with the N-type doped polysilicon layer 45.

Exemplarily, in the P-type back contact solar cell, the third passivation layer 42 may be an aluminum oxynitride layer, an aluminum oxide layer, a silicon dioxide layer, etc.; the fourth protective layer 43 may be a silicon nitride layer, etc.; and the seventh protective layer 47 may be a silicon nitride layer, etc.

Further, the third passivation layer 42 is optionally the aluminum oxynitride layer. When the third passivation layer 42 is the aluminum oxynitride layer, since the aluminum oxynitride layer has a high hydrogen content, the aluminum oxynitride layer has a better hydrogen passivation effect compared to silicon dioxide. Additionally, compared to the silicon dioxide, silicon oxynitride experiences less degradation in passivation quality under ultraviolet irradiation, and has superior uvioresistant stability, thereby allowing for better long-term stability of the solar cell. By arranging a film layer containing the aluminum oxynitride layer on both the fifth side and the sixth side of the second N-type silicon wafer, the passivation effects on both a front side and a back side of the N-type back contact solar cell are significantly enhanced, which is conducive to improving the photoelectric conversion efficiency.

From the structures of the above-mentioned solar cells 100, 200, 300, and 400, it can be observed that when the dielectric layer is applied to the solar cell, the dielectric layer needs to be in contact with various P-type substrates or N-type substrates, and the protective layer is required on another side of the dielectric layer. The arrangement of the protective layer, on one hand, prevents the dielectric layer from damage in a high-temperature sintering process for electrode formation, and on the other hand, can function as an anti-reflection layer to enhance the absorption of incident light by the solar cell.

In some embodiments, the protective layer may be deposited through a chemical vapor deposition method, such as being prepared using the chemical vapor deposition method, such as low pressure CVD (LPCVD), radio frequency CVD (RFCVD), and plasma enhanced CVD (PECVD).

In some embodiments, the protective layer includes one or a combination of more of silicon nitride, silicon oxynitride, silicon oxide, and silicon carbide. That is, the protective layer may be a single layer formed from a single material or includes a plurality of layers formed from various materials. The protective layer in an embodiment of the present application includes a first protective layer, a second protective layer, a third protective layer, a fourth protective layer, a fifth protective layer, a sixth protective layer, and a seventh protective layer.

In some embodiments, the hydrogen content of the protective layer is greater than or equal to 1 wt%, thereby further achieving chemical passivation of dangling bonds and reducing surface defects.

In some embodiments, a thickness of the protective layer is greater than or equal to 50 nm, while a thickness of the dielectric layer is less than 30 nm, resulting in a sum of thicknesses of the dielectric layer and the protective layer ranging from 75 nm to 85 nm. Therefore, the refractive index can be improved to the maximum degree, the optical interference effect can be better utilized, and the anti-reflection effect between the dielectric layer and the protective layer is improved. Exemplarily, the thickness sum may be any point value within the above-mentioned range, such as 75 nm, 76 nm, 77 nm, 78 nm, 79 nm, 80 nm, 81 nm, 82 nm, 83 nm, 84 nm, and 85 nm.

In a fourth aspect, the present application provides a photovoltaic module that includes the solar cell as described in the third aspect. The solar cells may be connected in series or parallel to form the photovoltaic module.

In a fifth aspect, the present application also provides a photovoltaic equipment that includes the photovoltaic module as described in the fourth aspect. The photovoltaic equipment may be a centralized photovoltaic power station, a distributed photovoltaic power station, a transportation photovoltaic power station, etc.

The technical solutions of the present application will be further described below in combination with specific examples and comparative examples:

Example 1

Referring to FIG. 3, Example 1 provides a back-passivated solar cell 100 with a composite dielectric layer. The back-passivated solar cell 100 includes:

a first P-type silicon wafer 11 having a first side and a second side opposite to each other, with the first side being a light-incident side;
an N-type diffusion layer 12 arranged on the first side;
a first passivation layer 13 arranged on a side of the N-type diffusion layer 12 facing away from the first P-type silicon wafer 11;
a first protective layer 14 arranged on a side of the first passivation layer 13 facing away from the first P-type silicon wafer 11;
a dielectric layer 15 including an aluminum oxide layer 151 and an aluminum oxynitride layer 152 sequentially stacked, with the aluminum oxide layer 151 being arranged on the second side;
a second protective layer 16 arranged on a side of the aluminum oxynitride layer 152 facing away from the first P-type silicon wafer 11; and
a first electrode structure including a first electrode 171 and a second electrode 172, with the first electrode 171 being in ohmic contact with the first P-type silicon wafer 11 and the second electrode 172 being in ohmic contact with the N-type diffusion layer 12.

This example further provides a preparation method for the above-mentioned back-passivated solar cell 100. The preparation method includes the following steps:

Texturing: in a tank-type device, an M10 silicon wafer was textured using sodium hydroxide and an additive of type TS40 in a volume ratio of 7:1 at a temperature of 80°C for a time of 7 min, with the thinning amount being controlled to 5 μm.

Boron diffusion: the textured silicon wafer was placed in a phosphorus diffusion furnace, and a boron source was deposited using nitrogen gas carrying phosphorus oxychloride ($POCl_3$) gas and oxygen gas ($O_2$) in a volume ratio of 2:1 at 780°C and then driven in at 840°C for 15 min to form a P-N junction.

Selectively heavily doping with laser: the front side of the silicon wafer was engraved by a 532 nm nanosecond laser with an energy of 40 W to form a pattern identical to the one screen-printed on the front side, with a region swept by the laser formed into a heavily-doped region.

Chain oxidation: an oxide layer was formed on the laser-engraved heavily-doped region just discussed through a chain oxidation device at a temperature of 650°C, with oxygen gas introduced at a flow rate of 40 SLM for 1 min, and with the first side of the silicon wafer oriented upwards.

Alkali polishing: in a chain-type HF machine, a hydrofluoric acid solution with a volume percent of 20% was used to remove the phosphorosilicate glass layer that was wrapped around the back side during the phosphorus diffusion; the silicon wafer was then transferred to a tank-type alkali polishing machine through a robotic arm, and sodium hydroxide NaOH and an alkali polishing additive BP31 in a volume ratio of 3:1 were used to polish the back side and remove the P-N junction that was wrapped around the back side and edges in the boron diffusion step, at a temperature of 80°C for a time of 7 min; and finally, the silicon wafer was transferred into an acid tank, and a hydrofluoric acid with a mass concentration of 5% was used to remove the phosphorosilicate glass layer that was wrapped around the front side and remove the oxide layer on the heavily-doped region.

Front thermal oxidation: using a tubular oxidation furnace, the silicon wafer was placed in a quartz boat with the first side oriented outwards and oxidated for 20 min with oxygen gas at a flow rate of 10 SLM.

Dielectric layer deposition: first, using a tubular ALD device, an aluminum oxide layer was deposited and then an aluminum oxynitride layer was deposited, with a process temperature being 350°C and flow rates of gases controlled at 50 sccm, specifically including:

① aluminum oxide layer deposition: first introducing $Al(CH_3)_3$ gas for 10 s, followed by evacuation for 10 s, and then, introducing $H_2O$ gas for 10 s, followed by evacuation for 10 s, where after the sequential introduction and evacuation of the above-mentioned two gases, one growth cycle was completed, and a total of 5 growth cycles above were performed to deposit an aluminum oxide layer with a thickness of 2 nm; and

② aluminum oxynitride layer deposition: maintaining the number of growth cycles with the introduction of the aluminum source and the oxygen source at 5: in one growth cycle, introducing $Al(CH_3)_3$ gas for 10 s, followed by evacuation for 10 s, and then introducing $H_2O$ gas for 10 s, followed by evacuation for 10 s; maintaining the number of growth cycles with the introduction of the aluminum source, the oxygen source, and the nitrogen source at 15: in one growth cycle, introducing $Al(CH_3)_3$ gas for 10 s, followed by evacuation for 10 s, then introducing $H_2O$ gas for 10 s, followed by evacuation for 10 s, and finally, introducing $NH_3$ gas for 20 s, followed by evacuation for 10 s, resulting in a total of 25 growth cycles to deposit an aluminum oxynitride layer with a thickness of 3 nm.

Second protective layer deposition: the silicon wafer was transported to another tubular PECVD device, three silicon nitride layers were deposited on the back side of the silicon wafer; first, the above-mentioned silicon wafer was placed into a graphite boat with the first side of the silicon wafer positioned adjacent to the graphite boat and the back side of the silicon wafer oriented outwards; then, in a reaction furnace tube, the temperature in the tube was increased to 550°C, the silicon wafer was stayed in a nitrogen atmosphere for 15 min, the pressure was evacuated to 2000 mTorr, and a protective layer, composed of the three silicon nitride layers, was deposited, where the total deposition process time was 60 min, the total thickness of the protective layer was 55 nm, and the total thickness of the dielectric layer and the protective layer was 60 nm.

Front first passivation layer deposition: in the tubular PECVD device, a silicon nitride layer, a silicon oxynitride layer, and a silicon oxide layer were sequentially deposited, with a total thickness being 80 nm.

Back laser slotting: the back side was engraved by a 532 nm nanosecond green laser with a duty cycle of 0.5:0.5 to form a back screen-printing pattern and remove back film layers in the corresponding regions allow a metallization paste to make contact with the P-type silicon wafer.

Screen printing: an aluminum paste was printed on the back side, and a first electrode was fabricated through a sintering process at a temperature of 800°C; a silver paste was printed on the front side, and a second electrode was fabricated through a sintering process at a temperature of 800°C; and electric injection into the cell was completed at a process temperature of 200°C.

Example 2

Referring to FIG. 2, Example 2 also provides a back-passivated solar cell 100. A dielectric layer 15 of the back-passivated solar cell 100 is an aluminum oxynitride layer. Similarly, in a preparation method for the back-passivated solar cell 100, the aluminum oxynitride layer is deposited through the ALD method, with the rest remaining consistent with Example 1.

Example 3

Referring to FIG. 5, Example 3 provides a passivated contact solar cell 200 with a composite dielectric layer. The passivated contact solar cell 200 includes:

a first N-type silicon wafer 21 having a third side and a fourth side opposite to the third side, with the third side being a light-incident side;
a P-type diffusion layer 22 arranged on the third side;
a dielectric layer 23 including an aluminum oxide layer 231 and an aluminum oxynitride layer 232 sequentially stacked, with the aluminum oxide layer 231 being arranged on a side of the P-type diffusion layer 22 facing away from the first N-type silicon wafer 21;
a third protective layer 24 arranged on a side of the aluminum oxynitride layer 232 facing away from the first N-type silicon wafer 21;
a first tunneling oxide layer 25 arranged on the fourth side;
a first doped polysilicon layer 26 arranged on a side of the first tunneling oxide layer 25 facing away from the first N-type silicon wafer 21;
a first anti-reflection layer 27 arranged on a side of the first doped polysilicon layer 26 facing away from the first N-type silicon wafer 21; and
a second electrode structure including a third electrode 281 and a fourth electrode 282, with the third electrode 281 being in ohmic contact with the P-type diffusion layer 22 and the fourth electrode 282 being in ohmic contact with the first doped polysilicon layer 26.

This example further provides a preparation method for the passivated contact solar cell 200. The preparation steps include:
Texturing: in a tank-type device, an N-type M10 silicon wafer was textured with sodium hydroxide and an additive of type TS40 in a volume ratio of 7:1 at a temperature of 80°C for a time of 7 min, with the thinning amount controlled to 5 $\mu$m.
Boron diffusion: the textured silicon wafer was placed in a boron diffusion furnace; and a boron source was deposited with boron trichloride gas and oxygen gas in a volume ratio of 1:3 at 830°C, and then driven in at 1030°C for 1 h to form a P-N junction.
Alkaline polishing: in a chain-type HF machine, a hydrofluoric acid solution with a volume percent of 50% was used to remove the borosilicate glass that was wrapped around the back side during the boron diffusion; and then the silicon wafer was transferred to a tank-type alkali polishing machine through a robotic arm, and sodium hydroxide and an alkali polishing additive BP31 in a volume ratio of 3:1 were used to polish the back side and remove the P-N junction that was wrapped around the back side and edges in the boron diffusion step, with the temperature maintained at 80°C for a time of 7 min.
Fabrication of a first tunneling oxide layer and a first doped polysilicon layer on the back side: using a tubular PECVD device, the first tunneling oxide layer (silicon oxide layer), an intrinsic amorphous silicon layer, a phosphorus-doped amorphous silicon layer, and a silicon oxynitride mask layer were deposited on the back side of the silicon wafer at a pressure of 3000 mTorr.
Annealing: using a tubular annealing furnace, the silicon wafer was annealed in a proportional gas atmosphere of nitrogen at 10 SLM at a temperature of 900°C for a time of 120 min, with an annealing duration of 2700 s, to convert a crystal structure of the deposited amorphous silicon layer to form a polysilicon layer.
RCA cleaning: first the oxide layer on a single side, the front side, was removed with a hydrofluoric acid having a mass concentration of 5% through a chain-type device; the silicon wafer was then transferred into the tank-type alkali polishing machine through the robotic arm, and sodium hydroxide NaOH and the alkali polishing additive BP31 in a volume ratio of 2:1 were used to remove the polysilicon film layer that was wrapped around the front side during deposition and the annealing step, at a temperature of 80°C for a time of 2 min; and finally the silicon wafer was transferred into an acid tank, and a hydrofluoric acid with a mass concentration of 5% was used to remove the borosilicate glass layer on the front side and the mask layer on the back side.
Dielectric layer deposition: first, using a tubular ALD device, on the front boron-diffused side of the N-type silicon wafer, an aluminum oxide layer was deposited and then an aluminum oxynitride layer was deposited, with a process temperature being 350°C and flow rates of gases being 50 sccm, specifically including:

① aluminum oxide layer deposition: first introducing $Al(CH_3)_3$ gas for 10 s, followed by evacuation for 10 s, and then, introducing $H_2O$ gas for 10 s, followed by evacuation for 10 s, where after the sequential introduction and evacuation of the above-mentioned two gases, one growth cycle was completed, and a total of 3 growth cycles above were performed to deposit an aluminum oxide layer with a thickness of 1 nm; and
② aluminum oxynitride layer deposition: maintaining the number of growth cycles with the introduction of the aluminum source and the oxygen source at 15: in one growth cycle, introducing $Al(CH_3)_3$ gas for 10 s, followed by evacuation for 10 s, and then introducing $H_2O$ gas for 10 s, followed by evacuation for 10 s; maintaining the number of growth cycles with the introduction of the aluminum source, the oxygen source, and the nitrogen source at 15: in one growth cycle, introducing $Al(CH_3)_3$ gas for 10 s, followed by evacuation for 10 s, then introducing $H_2O$ gas for 10 s, followed by evacuation for 10 s, and finally, introducing $NH_3$ gas for 20 s, followed by evacuation for 10 s, resulting in a total of 30 growth cycles to deposit an aluminum oxynitride layer with a thickness of 5 nm.

Protective layer deposition: the silicon wafer was transported to another tubular PECVD device, and a protective layer was deposited on the back side of the silicon wafer, where the protective layer was a composite protective layer of a silicon nitride layer and a silicon oxynitride layer. First, the above-mentioned silicon wafer was placed into a graphite boat, with the back side of the silicon wafer positioned adjacent to the graphite boat and the front side of the silicon wafer oriented outwards; and then, in a reaction furnace tube, the temperature in the tube was increased to 550°C, the silicon wafer was stayed in a nitrogen atmosphere for 15 min, then the pressure was evacuated to 2000 mTorr, and the silicon nitride layer and the silicon oxynitride layer were deposited, where the total deposition process time was 50 min, the total thickness of the protective layer was 74 nm, the hydrogen content of the protective layer was 5%, and the total thickness of the dielectric layer and the protective layer was 80 nm.

First anti-reflection layer deposition: the silicon nitride layer with a thickness of 80 nm was deposited through PEVCD.

Screen printing: a silver paste was printed on the back side, and a fourth electrode was fabricated through a sintering process at a temperature of 840°C; a silver-aluminum paste was printed on the front side, and a third electrode was fabricated through a sintering process at a temperature of 840°C; and light injection into the passivated contact solar cell was completed at a process temperature of 700°C.

Example 4

Referring to FIG. 4, Example 4 also provides a passivated contact solar cell 200. A dielectric layer 23 of the passivated contact solar cell 200 is an aluminum oxynitride layer. Similarly, in a preparation method for the passivated contact solar cell 200, the aluminum oxynitride layer is deposited using the ALD method, with the rest remaining consistent with Example 1.

Example 5

Example 5 provides a back-passivated solar cell. The difference from Example 1 lies in that, in the step of fabricating the aluminum oxynitride layer in Example 5, the simultaneous introduction of the aluminum source, the oxygen source, and the nitrogen source occurs twenty times.

Example 6

Example 6 provides a back-passivated solar cell. The difference from Example 1 lies in that, in the step of fabricating the aluminum oxynitride layer in Example 6, the simultaneous introduction of the aluminum source, the oxygen source, and the nitrogen source occurs twenty-five times.

Example 7

Referring to FIG. 9, Example 7 provides a P-type IBC solar cell 400 with a composite dielectric layer. The P-type IBC solar cell 400 includes:

a second P-type silicon wafer 41 having a seventh side and an eighth side opposite to the seventh side, with the seventh side being a light-incident side;
a third passivation layer 42 arranged on the seventh side;
a sixth protective layer 43 arranged on a side of the third passivation layer 42 facing away from the second P-type silicon wafer 41;

a third tunneling oxide layer 44 arranged on the eighth side;

an N-type doped polysilicon layer 45 arranged on a side of the third tunneling oxide layer 44 facing away from the second P-type silicon wafer 41;

a dielectric layer 46 including a sixth part 461 and a seventh part 462, where

the sixth part 461 includes a fourth aluminum oxide layer 4611 and a fourth aluminum oxynitride layer 4612 sequentially stacked, with the fourth aluminum oxide layer 4611 being arranged on the eighth side; and

the seventh part 462 includes a fifth aluminum oxide layer 4621 and a fifth aluminum oxynitride layer 4622 sequentially stacked, with the fifth aluminum oxide layer 4621 arranged on a side of the N-type doped polysilicon layer 45 facing away from the second P-type silicon wafer 41;

a seventh protective layer 47 arranged on sides of the fourth aluminum oxynitride layer 4612 and the fifth aluminum oxynitride layer 4622 facing away from the second N-type silicon wafer 41; and

a fourth electrode structure including a seventh electrode 481 and an eighth electrode 482, with the seventh electrode 481 being in ohmic contact with the second P-type silicon wafer 41 and the eighth electrode 482 being in ohmic contact with the N-type doped polysilicon layer 45.

This example further provides a preparation method for the P-type IBC solar cell 400. The preparation steps include:

Polishing: in a tank-type device, both sides of a P-type M10 silicon wafer were polished with sodium hydroxide and an alkali polishing additive BP31 in a volume ratio of 3:1 at a temperature of 80°C for a time of 7 min.

Fabrication of a first tunneling oxide layer and a first doped polysilicon layer on the back side: using a tubular PECVD device, the first tunneling oxide layer (silicon oxide layer), an intrinsic amorphous silicon layer, a phosphorus-doped amorphous silicon layer, and a silicon oxynitride mask layer were deposited on the back side of the silicon wafer at a pressure of 3000 mTorr.

Annealing: using a tubular annealing furnace, the silicon wafer was annealed in a proportional gas atmosphere of nitrogen at 10 SLM at a temperature of 900°C for a time 120 min, with an annealing time of 2700 s, to convert a crystal structure of the deposited amorphous silicon layer to form a polysilicon layer.

Laser slotting: the deposited polysilicon layer on the back side of the silicon wafer was engraved by a 532 nm nanosecond laser with an energy of 40 W to form a specific pattern of P-type region, with a region not engraved by laser being an N-type region.

Texturing: through a chain-type HF machine, a hydrofluoric acid solution with a volume percent of 50% was used to remove the silicon oxynitride mask layer that was wrapped around the front side during the poly deposition on the front side; the silicon wafer was then transferred to a tank-type texturing machine through a robotic arm and textured using sodium hydroxide and an additive of type TS40 in a volume ratio of 7:1 at a temperature of 80°C for a time of 7 min, where the N-type region on the back side that was not engraved by laser was not affected due to the protection of the silicon oxynitride mask layer, while a textured surface being formed at regions of the front side and the back side that was engraved by laser.

Dielectric layer deposition: first, using a tubular ALD device, the dielectric layer was deposited on both sides at a process temperature of 270°C and at gas flow rates controlled at 50 sccm, with the aluminum oxide layer being deposited first and then the aluminum oxynitride layer being deposited, specifically including:

① aluminum oxide layer deposition: first introducing $Al(CH_3)_3$ gas for 10 s, followed by evacuation for 10 s, and then, introducing $H_2O$ gas for 10 s, followed by evacuation for 10 s, where after the sequential introduction and evacuation of the above-mentioned two gases, one growth cycle was completed, and a total of 5 growth cycles were performed above to deposit an aluminum oxide layer with a thickness of 2 nm; and

② aluminum oxynitride layer deposition: maintaining the number of growth cycles with the introduction of the aluminum source and the oxygen source at 15: in one growth cycle, introducing $Al(CH_3)_3$ gas for 10 s, followed by evacuation for 10 s, and then introducing $H_2O$ gas for 10 s, followed by evacuation for 10 s; maintaining the number of growth cycles with the introduction of the aluminum source, the oxygen source, and the nitrogen source at 15: in one growth cycle, introducing $Al(CH_3)_3$ gas for 10 s, followed by evacuation for 10 s, then introducing $H_2O$ gas for 10 s, followed by evacuation for 10 s, and finally, introducing $NH_3$ gas for 20 s, followed by evacuation for 10 s, resulting in a total of 30 growth cycles to deposit an aluminum oxynitride layer with a thickness of 4 nm.

Protective layer deposition: the silicon wafer was transported to another tubular PECVD device, and a protective layer was deposited on the front side of the silicon wafer, where the protective layer was a composite protective layer of a silicon nitride layer and a silicon oxynitride layer. First, the above-mentioned silicon wafer was placed into a graphite boat, with the back side of the silicon wafer positioned adjacent to the graphite boat and the front side of the silicon wafer oriented outwards; and then, in a reaction furnace tube, the temperature in the tube was increased to 550°C, the silicon wafer was stayed in a nitrogen atmosphere for 15 min, then the pressure was evacuated to 2000 mTorr, and the silicon nitride layer and the silicon oxynitride layer were deposited, where the total deposition process time was 50 min, the total thickness of the protective layer was 74 nm, the hydrogen content of the protective layer was 5%, and the total thickness of the dielectric layer and the protective layer was 80 nm.

Second protective layer deposition: the silicon nitride layer with a thickness of 80 nm was deposited on the back side of the silicon wafer through PECVD

Screen printing: an aluminum paste was printed on the back side, and a fourth electrode was fabricated through a sintering process at a temperature of 840°C; a silver paste was printed on the back side, and a third electrode was fabricated through a sintering process at a temperature of 840°C; and light injection into the passivated contact solar cell was completed at a process temperature of 300°C.

Example 8

Referring to FIG. 8, Example 8 also provides a P-type IBC solar cell 400. A dielectric layer 46 of the P-type IBC solar cell 400 is an aluminum oxynitride layer. Similarly, in a preparation method for the P-type IBC solar cell 400, the aluminum oxynitride layer is deposited using the ALD method, with the rest remaining consistent with Example 7.

Example 9

Referring to FIG. 7, Example 7 provides an N-type IBC solar cell 300 with a composite dielectric layer. The N-type IBC solar cell 400 includes:

a second N-type silicon wafer 31 having a fifth side and a sixth side opposite to the fifth side, with the fifth side being a light-incident side;
a second passivation layer 32 arranged on the fifth side, the second passivation layer 32 being an aluminum oxynitride layer;
a fourth protective layer 33 arranged on a side of the second passivation layer 32 facing away from the second N-type silicon wafer 31;
a second tunneling oxide layer 34 including a first part 341 and a second part 342, with the first part 341 and the second part 342 being arranged on the sixth side;
a second doped polysilicon layer including a P-type doped polysilicon layer 351 and an N-type doped polysilicon layer 352, with the P-type doped polysilicon layer 351 being arranged on a side of the first part 341 facing away from the second N-type silicon wafer 31 and the N-type doped polysilicon layer 352 being arranged on a side of the second part 342 facing away from the second N-type silicon wafer 31;
a dielectric layer 36 including a third part 361, a fourth part 362, and a fifth part 363, where
the third part 361 includes a first aluminum oxide layer 3611 and a first aluminum oxynitride layer 3612 sequentially stacked, with the first aluminum oxide layer 3611 being arranged on a side of the P-type doped polysilicon layer 351 facing away from the second N-type silicon wafer 31;
the fourth part 362 includes a second aluminum oxide layer 3621 and a second aluminum oxynitride layer 3622 sequentially stacked, with the second aluminum oxide layer 3621 being arranged on the sixth side and between the P-type doped polysilicon layer 351 and the N-type doped polysilicon layer 352; and
the fifth part 363 includes a third aluminum oxide layer 3631 and a third aluminum oxynitride layer 3632 sequentially stacked, with the third aluminum oxide layer 3631 being arranged on a side of the N-type doped polysilicon layer 352 facing away from the second N-type silicon wafer 31; and
a fifth protective layer 37 arranged on sides of the first aluminum oxynitride layer 3612, the second aluminum oxynitride layer 3622, and the third aluminum oxynitride layer 3632 facing away from the second N-type silicon wafer 31; and
a third electrode structure including a fifth electrode 381 and a sixth electrode 382, with the fifth electrode 381 being in ohmic contact with the P-type doped polysilicon layer 351 and the sixth electrode 382 being in ohmic contact with the N-type doped polysilicon layer 352.

This example further provides a preparation method for the N-type IBC solar cell 300. The preparation steps include:
Polishing: in a tank-type device, both sides of an N-type M10 silicon wafer were polished with sodium hydroxide and an alkali polishing additive BP31 in a volume ratio of 3:1 at a temperature 80°C for a time of 7 min.

Deposition of intrinsic amorphous silicon 1: using a tubular LPCVD device, a silicon oxide layer as a first tunneling oxide layer and an intrinsic amorphous silicon layer were deposited on the back side of the silicon wafer at 565°C.

Boron diffusion: the silicon wafer obtained in the previous step was placed into a boron diffusion furnace; and a boron source was deposited using boron trichloride gas and oxygen gas in a volume ratio of 1:3 under condition of a temperature of 800°C, and then driven in at 920°C for 20 min to form a P-type doped polysilicon layer, with a sheet resistance after diffusion of 100 $\Omega$/sq to 120 $\Omega$/sq.

Laser film opening 1: the borosilicate glass generated during the boron diffusion process was retained, and the P-type doped polysilicon layer obtained on the back side of the substrate in the previous step was locally slotted by laser to remove the P-type doped polysilicon layer in regions 362 and 352.

Alkali polishing: the remaining P-type doped polysilicon layer and laser damage in the slotted regions from the previous step were etched away to form a back side field region 352 while an unslotted and unetched region is an emitter region 351.

Deposition of intrinsic amorphous silicon 2: using a tubular LPCVD device, a silicon oxide layer as a second tunneling oxide layer and an intrinsic amorphous silicon layer were deposited on the back side of the silicon wafer at 610°C.

Phosphorus diffusion: using a tubular diffusion furnace, phosphorus diffusion was performed on the silicon wafer in a gas atmosphere of nitrogen gas, oxygen gas, and vaporized phosphorus oxychloride, with nitrogen gas at 6 SLM, oxygen gas at 6 SLM, and phosphorus oxychloride at 1000 sccm, at a temperature of 850 °C to 950 °C for a time of 100 min to dope the intrinsic amorphous silicon film deposited in the previous step with phosphorus, forming a phosphorus-doped polysilicon layer 352.

Laser film opening 2: the N-type doped polysilicon layer obtained on the back side of the substrate in the previous step was locally slotted by laser to remove the N-type doped polysilicon layer on the P-type doped polysilicon layers 351 and 362, where the P-type doped polysilicon layer 351 was not removed by the laser due to the protection of the borosilicate glass layer thereon.

Texturing: using a chain-type HF machine, the phosphorus silicate glass and the borosilicate glass on the front side of the silicon wafer was removed with a hydrofluoric acid solution with a volume percent of 5%; the silicon wafer was transferred into a tank-type texturing machine through a robotic arm, and with the remaining phosphorus silicate glass and borosilicate glass generated due to the boron diffusion and the phosphorus diffusion on the back side was retained as a back mask, the front side of the substrate 31 is textured with a texturing solution to formed an anti-reflection textured surface.

Dielectric layer deposition: using a tubular ALD device, the dielectric layer was deposited on both sides at a process temperature of 270°C, with gas flow rates controlled at 50 sccm, where the aluminum oxide layer was first deposited, and then the aluminum oxynitride layer was deposited, specifically including:

① aluminum oxide layer deposition: first introducing $Al(CH_3)_3$ gas for 10 s, followed by evacuation for 10 s, and then introducing $H_2O$ gas for 10 s, followed by evacuation for 10 s, where after the sequential introduction and evacuation of the above-mentioned two gases, one growth cycle was completed, and a total of 5 growth cycles above were performed to deposit an aluminum oxide layer with a thickness of 2 nm; and

② aluminum oxynitride layer deposition: maintaining the number of growth cycles with the introduction of the aluminum source and the oxygen source at 15: in one growth cycle, introducing $Al(CH_3)_3$ gas for 10 s, followed by evacuation for 10 s, and then introducing $H_2O$ gas for 10 s, followed by evacuation for 10 s; maintaining the number of growth cycles with the introduction of the aluminum source, the oxygen source, and the nitrogen source at 15: in one growth cycle, introducing $Al(CH_3)_3$ gas for 10 s, followed by evacuation for 10 s, then introducing $H_2O$ gas for 10 s, followed by evacuation for 10 s, and finally introducing $NH_3$ gas for 20 s, followed by evacuation for 10 s, resulting in a total of 30 growth cycles to deposit an aluminum oxynitride layer with a thickness of 4 nm.

Protective layer deposition: the silicon wafer was transported to another tubular PECVD device, and a protective layer was deposited on the front side of the silicon wafer, where the protective layer was a composite protective layer of a silicon nitride layer and a silicon oxynitride layer. First, the above-mentioned silicon wafer was placed into a graphite boat, with the back side of the silicon wafer positioned adjacent to the graphite boat and the front side of the silicon wafer oriented outwards; and then in a reaction furnace tube, the temperature in the tube was increased to 550°C, the silicon wafer was stayed in a nitrogen atmosphere for 15 min, then the pressure was evacuated to 2000 mTorr, and the silicon nitride layer and the silicon oxynitride layer were deposited, where the total deposition process time was 50 min, the total thickness of the protective layer was 74 nm, the hydrogen content of the protective layer was 5%, and the total thickness of the dielectric layer and the protective layer was 80 nm.

Second protective layer deposition: a silicon nitride layer with a thickness of 80 nm was deposited on the back side of the silicon wafer through PECVD.

Screen printing: a silver paste was printed on the back side, and a fifth electrode was fabricated through a sintering process at a temperature of 840°C; a silver paste was printed on the back side, and a sixth electrode was fabricated through a sintering process at a temperature of 840°C; and light injection into the passivated contact solar cell was completed at a process temperature of 300°C.

Example 10

Referring to FIG. 6, Example 7 also provides an N-type IBC solar cell 300. A dielectric layer 36 of the N-type IBC solar cell 300 is an aluminum oxynitride layer. Similarly, in a preparation method for the N-type IBC solar cell 300, the aluminum oxynitride layer was deposited using the ALD method, with the rest remaining consistent with Example 9.

Comparative Example 1

Comparative Example 1 provides a back-passivated solar cell with a dielectric layer being an aluminum oxide layer. In a preparation method for the back-passivated solar cell, the aluminum oxide layer is deposited using the ALD method, with the rest remaining consistent with Example 1.

Comparative Example 2

Comparative Example 2 provides a passivated contact solar cell with a dielectric layer being an aluminum oxide layer. In a preparation method for the passivated contact solar cell, the aluminum oxide layer is deposited using the ALD method, with the rest remaining consistent with Example 3.

Comparative Example 3

Comparative Example 3 provides a back-passivated solar cell. The difference from Example 1 lies in that, in the step of fabricating the aluminum oxynitride layer in Example 6, the simultaneous introduction of the aluminum source, the oxygen source, and the nitrogen source occurs five times.

Comparative Example 4

Comparative Example 4 provides a back-passivated solar cell. The difference from Example 1 lies in that, in the step of fabricating the aluminum oxynitride layer in Example 6, the simultaneous introduction of the aluminum source, the oxygen source, and the nitrogen source occurs nine times.

Comparative Example 5

Comparative Example 5 provides a P-type IBC solar cell with a dielectric layer being an aluminum oxide layer. In a preparation method for the passivated contact solar cell, the aluminum oxide layer is deposited using the ALD method, with the rest remaining consistent with Example 7.

Comparative Example 6

Comparative Example 6 provides an N-type IBC solar cell with a dielectric layer being an aluminum oxide layer. In a preparation method for the passivated contact solar cell, the aluminum oxide layer is deposited using the ALD method, with the rest remaining consistent with Example 7.

Testing and Data Analysis

Samples of dielectric layers in Examples 1, 5, and 6, and Comparative Examples 3 and 4 were provided. Using a second ion mass spectroscopy (SIMS) instrument, sample surfaces were continuously bombarded with a primary ion beam, causing sputtering of atomic layers on the sample surfaces and emitting positive ions, negative ions, neutral particles, photons, etc., and elemental analysis was achieved by collecting charged particles with specific charge-to-mass ratios, with analysis results as follows:

Table 1 Elemental Analysis of Dielectric Layers in Solar Cells in Examples 1, 5, and 6, and Comparative Examples 3 and 4

| Group | Nitrogen Source Introduction Times | Al (%) | O (%) | N (%) | C (%) | H (%) | Photoelectric conversion efficiency (%) |
|---|---|---|---|---|---|---|---|
| Comparative Example 3 | 5 | 38.0 | 60.0 | 0.6 | 0.2 | 1.8 | 23.31 |
| Comparative Example 4 | 9 | 38.0 | 55.0 | 3.6 | 0.3 | 3.3 | 23.32 |

(continued)

| Group | Nitrogen Source Introduction Times | Al (%) | O (%) | N (%) | C (%) | H (%) | Photoelectric conversion efficiency (%) |
|---|---|---|---|---|---|---|---|
| Example 1 | 15 | 38.0 | 52.0 | 5.3 | 0.2 | 4.6 | 23.37 |
| Example 5 | 20 | 39.0 | 32.0 | 20.0 | 1.2 | 8.5 | 23.37 |
| Example 6 | 25 | 40.0 | 14.5 | 32.6 | 2.4 | 10.4 | 23.36 |

From Table 1, it can be seen that in Comparative Examples 3 and 4, the number of times (n) that the nitrogen source is introduced during the growth cycle is less than 10, and these Comparative Examples fail to achieve the nitrogen content of 4 wt% and the hydrogen content of 4 wt%, so that the photoelectric conversion efficiencies of Comparative Examples 3 and 4 are inferior to those of Example 1, Example 5, and Example 6.

The performances of the solar cells in Examples 1 to 4 and Comparative Examples 1 and 2 were tested, and the electrical properties of the cells were tested using a Halm testing machine, with results as follows:

Table 2 Performances of Back-Passivated Solar Cells in Examples 1 and 2 and Comparative Example 1

| Group | Open-Circuit Voltage (V) | Short-Circuit Current (mA/cm$^2$) | Fill Factor (%) | Photoelectric Conversion Efficiency (%) |
|---|---|---|---|---|
| Example 1 | 0.6916 | 41.96 | 80.53 | 23.37 |
| Example 2 | 0.6914 | 41.98 | 80.48 | 23.36 |
| Comparative Example 1 | 0.6908 | 41.89 | 80.56 | 23.31 |

Table 3 Performances of Passivated Contact Solar Cells in Examples 3 and 4 and Comparative Example 2

| Group | Open-Circuit Voltage (V) | Short-Circuit Current (mA/cm$^2$) | Fill Factor (%) | Photoelectric Conversion Efficiency (%) |
|---|---|---|---|---|
| Example 3 | 0.7193 | 41.52 | 84.38 | 25.20 |
| Example 4 | 0.7191 | 41.54 | 84.33 | 25.19 |
| Comparative Example 2 | 0.7184 | 41.45 | 84.32 | 25.11 |

Table 4 Performances of P-type Back Contact Solar Cells in Examples 7 and 8 and Comparative Example 5

| Group | Open-Circuit Voltage (V) | Short-Circuit Current (mA/cm$^2$) | Fill Factor (%) | Photoelectric Conversion Efficiency (%) |
|---|---|---|---|---|
| Example 7 | 0.7278 | 42.00 | 81.60 | 24.94 |
| Example 8 | 0.7277 | 42.02 | 81.61 | 24.95 |
| Comparative Example 5 | 0.7271 | 41.94 | 81.57 | 24.87 |

Table 5 Performances of N-type Back Contact Solar Cells in Examples 9 and 10 and Comparative Example 6

| Group | Open-Circuit Voltage (V) | Short-Circuit Current (mA/cm$^2$) | Fill Factor (%) | Photoelectric Conversion Efficiency (%) |
|---|---|---|---|---|
| Example 9 | 0.7378 | 42.62 | 81.45 | 25.61 |
| Example 10 | 0.7379 | 42.61 | 81.46 | 25.61 |
| Comparative Example 6 | 0.7371 | 42.53 | 81.40 | 25.52 |

From the combined data results of Example 1 and Comparative Example 1 in Table 2, Example 3 and Comparative Example 2 in Table 3, Example 7 and Comparative Example 5 in Table 4, and Example 9 and Comparative Example 6 in Table 5, it can be seen that replacing the aluminum oxide layer with the composite dielectric layer of the aluminum oxynitride layer and the aluminum oxide layer leads to superior photoelectric conversion efficiency. Since the passivation quality of the composite dielectric layer is superior, the solar cell using the composite dielectric layer exhibits a higher open-circuit voltage. Meanwhile, the composite dielectric layer has a higher refractive index, leading to superior current performance of the solar cells. Through the above-mentioned synergistic effects, the photoelectric conversion efficiency of the solar cells is enhanced to a certain extent.

In Example 2, Example 4, Example 8, and Example 10, a single aluminum oxynitride layer is used as the dielectric layer. When compared to the composite dielectric layer of the aluminum oxynitride layer and the aluminum oxide layer used in Example 1, Example 3, Example 7, and Example 9, the photoelectric conversion efficiencies of both configurations are similar. The composite dielectric layer offers superior passivation quality, leading to a higher open-circuit voltage of the solar cell using the composite film. Whereas, the single aluminum oxynitride layer exhibits a higher refractive index, resulting in better current performance of the solar cell using the single dielectric layer.

In summary, by selecting the specific material of the dielectric layer and controlling the element contents thereof, the present application can achieve a synergistic effect that increases the charge capacity of the dielectric layer, enhances the interface continuity of the dielectric layer, and reduces the interface defect density, thereby improving the passivation quality. Additionally, the refractive index can be effectively improved to enhance the absorption of the incident light, ultimately leading to a comprehensive improvement in the photoelectric conversion efficiency of the solar cell. The dielectric layer includes aluminum oxynitride with a high density of negative charges, which can reduce the loss of short-circuit current density. Additionally, the high density of negative charges can facilitate field passivation and reduce a concentration of carriers near an interface of the solar cell, thereby reducing the carrier recombination. The aluminum oxynitride exhibits an excellent growth property, which can reduce interface roughness, improve interface continuity, and reduce the distribution of dangling bonds. By controlling the element contents of the dielectric layer to cause the nitrogen content of the dielectric layer to be greater than 4 wt%, nitrogen bonding with hydrogen introduces additional hydrogen atoms, so that the hydrogen content is maintained above 4 wt%, thereby providing sufficient hydrogen atoms for chemical passivation, saturating the dangling bonds at the interface, reducing defect recombination centers, and lowering the interface defect density. An increase in the nitrogen content enhances the compactness of the dielectric layer, thereby increasing the refractive index, improving an anti-reflection effect of the solar cell, and increasing the absorption of the incident light.

The above provides a detailed introduction to the dielectric layer, the preparation method, the solar cell, and the photovoltaic module disclosed in the embodiments of the present application. Herein, specific examples are applied to elaborate the principle and the implementations of the present application, and the description of the above-mentioned embodiments is only used for assisting in understanding the dielectric layer, the preparation method, the solar cell, and the photovoltaic module in the present application and core concepts thereof; and meanwhile, those of ordinary skill in the art may change the specific implementations and the application scope according to the concepts of the present application. In conclusion, the content of the specification should not be understood as limitations on the present application.

The technical features of the above-mentioned embodiments can be combined arbitrarily. In order to make the description concise, not all possible combinations of the technical features are described in the embodiments. However, as long as there is no contradiction in the combination of these technical features, the combinations should be considered as in the scope of the present application.

The above-described embodiments are only several implementations of the present application, and the descriptions are relatively specific and detailed, but they should not be construed as limiting the scope of the present application. It should be understood by those of ordinary skill in the art that various modifications and improvements can be made without departing from the concept of the present application, and all fall within the protection scope of the present application. Therefore, the patent protection of the present application shall be defined by the appended claims.

**Claims**

1. A dielectric layer for a solar cell, comprising an aluminum oxynitride layer containing hydrogen, wherein the dielectric layer has a nitrogen content greater than 4 wt% and a hydrogen content greater than 4 wt%.

2. The dielectric layer according to claim 1, wherein the dielectric layer comprises an aluminum oxynitride layer.

3. The dielectric layer according to claim 1 or 2, wherein the dielectric layer comprises a first dielectric layer and a second dielectric layer which are stacked.

4. The dielectric layer according to any one of claims 1 to 3, wherein the first dielectric layer comprises an aluminum oxynitride layer.

5. The dielectric layer according to any one of claims 1 to 4, wherein the second dielectric layer comprises any one of an aluminum oxide layer, a gallium oxide layer, a titanium dioxide layer, a zirconium dioxide layer, or a tantalum pentoxide layer.

6. The dielectric layer according to any one of claims 3 to 5, wherein the second dielectric layer is grown on a substrate which is a P-type substrate or an N-type substrate, and the first dielectric layer is arranged on a surface of the second dielectric layer facing away from the P-type substrate or the N-type substrate.

7. The dielectric layer according to any one of claims 3 to 6, wherein the second dielectric layer comprises an aluminum oxide layer.

8. The dielectric layer according to any one of claims 3 to 7, wherein the second dielectric layer has a thickness less than or equal to that of the first dielectric layer.

9. The dielectric layer according to any one of claims 1 to 8, wherein the dielectric layer has a thickness less than 30 nm.

10. The dielectric layer according to any one of claims 1 to 9, wherein the dielectric layer has a refractive index ranging approximately from 1.65 to 2.10.

11. The dielectric layer according to any one of claims 1 to 10, wherein the dielectric layer has a roughness ranging approximately from 0.15 nm to 0.3 nm.

12. The dielectric layer according to any one of claims 6 to 11, wherein the P-type substrate comprises any one of a P-type silicon wafer, a P-type epitaxially grown doped layer, or a P-type diffusion layer.

13. The dielectric layer according to any one of claims 6 to 12, wherein the N-type substrate comprises an N-type silicon wafer.

14. A preparation method for a dielectric layer, wherein the dielectric layer is the dielectric layer according to any one of claims 1 to 13, and the preparation method comprises the following steps:

    chemical adsorption: sequentially providing an aluminum source and an oxygen source, which are chemically adsorbed onto the surface of the P-type substrate or the N-type substrate, thereby completing one growth cycle, and repeating the growth cycle $x$ times to deposit the dielectric layer, wherein a nitrogen source is provided in at least 10 times of the $x$ times of the growth cycle, such that the dielectric layer has a nitrogen content greater than 4 wt% and a hydrogen content greater than 4 wt%; and
    standing: allowing the dielectric layer to stand in an inert atmosphere at a temperature higher than or equal to 520°C for a time of 10 min to 40 min.

15. The preparation method according to claim 14, wherein the dielectric layer comprises a first dielectric layer and a second dielectric layer, and the chemical adsorption comprises the following steps:

    sequentially providing the aluminum source and the oxygen source, which are chemically adsorbed onto the surface of the P-type substrate or the N-type substrate, thereby completing one growth cycle, and repeating the growth cycle y times to deposit the second dielectric layer, where y is greater than 0; and
    sequentially providing the aluminum source and the oxygen source, which are chemically adsorbed onto a surface of the second dielectric layer facing away from the P-type substrate or the N-type substrate, thereby completing one growth cycle, and repeating the growth cycle z times to deposit the first dielectric layer, wherein the nitrogen source is provided in at least 10 times of the z times of the growth cycle.

16. The preparation method according to claim 15, wherein the standing comprises the following step: allowing the first dielectric layer and the second dielectric layer to stand in an inert atmosphere at a temperature of approximately 520°C to 600°C for a time of approximately 10 min to 40 min.

17. The preparation method according to claim 15 or 16, wherein $y$ is less than or equal to $z$.

18. The preparation method according to any one of claims 15 to 17, wherein in the step of depositing the second dielectric layer, a temperature of each growth cycle is approximately 250°C to 400°C.

19. The preparation method according to any one of claims 15 to 18, wherein in the step of depositing the first dielectric layer, a temperature of each growth cycle is approximately 250°C to 400°C.

20. The preparation method according to any one of claims 14 to 19, wherein the oxygen source, and the nitrogen source are each provided at a gas flow rate of approximately 20 sccm to 100 sccm.

21. The preparation method according to any one of claims 14 to 20, wherein the aluminum source is provided for a time of approximately 8 s to 12 s, the oxygen source is provided for a time of approximately 8 s to 12 s, and the nitrogen source is provided for a time of approximately 15 s to 25 s.

22. The preparation method according to any one of claims 14 to 21, wherein the aluminum source comprises one of or a mixture of more of $Al(CH_3)_3$, $AlCl_3$, $Al(CH_3)_2Cl$, and $(CH_3)_2(C_2H_5)N{:}AlH_3$.

23. The preparation method according to any one of claims 14 to 22, wherein the oxygen source comprises one of or a mixture of more of $H_2O$, $O_2$, $O_3$, $N_2O$, and $CO_2$.

24. The preparation method according to any one of claims 14 to 23, wherein the nitrogen source comprises one of or a mixture of more of $N_2O$ and $NH_3$.

25. A solar cell, comprising the dielectric layer according to any one of claims 1 to 13, wherein the dielectric layer is arranged on a surface of the P-type substrate or the N-type substrate, the solar cell further comprises a protective layer, and the protective layer is stacked on a surface of the dielectric layer facing away from the P-type substrate or the N-type substrate.

26. The solar cell according to claim 25, wherein the protective layer has a thickness greater than or equal to 50 nm.

27. The solar cell according to claim 25 or 26, wherein a sum of thicknesses of the dielectric layer and the protective layer is approximately 75 nm to 85 nm.

28. The solar cell according to any one of claims 25 to 27, wherein an effective refractive index of the dielectric layer and the protective layer is approximately 1.85 to 2.20.

29. The solar cell according to any one of claims 25 to 28, wherein a material of the protective layer comprises one of or a combination of more of silicon nitride, silicon oxynitride, silicon oxide, and silicon carbide, and the protective layer has a hydrogen content greater than or equal to 1 wt%.

30. The solar cell according to any one of claims 25 to 29, wherein the solar cell comprises any one of a back-passivated solar cell, a passivated contact solar cell, an N-type back contact solar cell, or a P-type back contact solar cell.

31. The solar cell according to any one of claims 25 to 30, wherein the solar cell is a back-passivated solar cell, which comprises:

a first P-type silicon wafer having a first side and a second side opposite to each other, with the first side being a light-incident side;
an N-type diffusion layer arranged on the first side;
a first passivation layer arranged on a side of the N-type diffusion layer facing away from the first P-type silicon wafer;
a first protective layer arranged on a side of the first passivation layer facing away from the first P-type silicon wafer;
a dielectric layer being an aluminum oxynitride layer and arranged on the second side;
a second protective layer arranged on a side of the aluminum oxynitride layer facing away from the first P-type silicon wafer; and
a first electrode structure comprising a first electrode and a second electrode, with the first electrode being in ohmic contact with the first P-type silicon wafer and the second electrode being in ohmic contact with the N-type diffusion layer.

32. The solar cell according to any one of claims 25 to 30, wherein the solar cell is a back-passivated solar cell, which comprises:

a first P-type silicon wafer having a first side and a second side opposite to each other, with the first side being a light-incident side;
an N-type diffusion layer arranged on the first side;
a first passivation layer arranged on a side of the N-type diffusion layer facing away from the first P-type silicon wafer;
a first protective layer arranged on a side of the first passivation layer facing away from the first P-type silicon wafer;
a dielectric layer comprising an aluminum oxide layer and an aluminum oxynitride layer sequentially stacked, with the aluminum oxide layer being arranged on the second side;
a second protective layer arranged on a side of the aluminum oxynitride layer facing away from the first P-type silicon wafer; and
a first electrode structure comprising a first electrode and a second electrode, with the first electrode being in ohmic contact with the first P-type silicon wafer and the second electrode being in ohmic contact with the N-type diffusion layer.

33. The solar cell according to any one of claims 25 to 30, wherein the solar cell is a passivated contact solar cell, which comprises:

a first N-type silicon wafer having a third side and a fourth side opposite to the third side, with the third side being a light-incident side;
a P-type diffusion layer arranged on the third side;
a dielectric layer being an aluminum oxynitride layer and arranged on a side of the P-type diffusion layer facing away from the first N-type silicon wafer;
a third protective layer arranged on a side of the aluminum oxynitride layer facing away from the first N-type silicon wafer;
a first tunneling oxide layer arranged on the fourth side;
a first doped polysilicon layer arranged on a side of the first tunneling oxide layer facing away from the first N-type silicon wafer;
a first anti-reflection layer arranged on a side of the first doped polysilicon layer facing away from the first N-type silicon wafer; and
a second electrode structure comprising a third electrode and a fourth electrode, with the third electrode being in ohmic contact with the P-type diffusion layer and the fourth electrode being in ohmic contact with the first doped polysilicon layer.

34. The solar cell according to any one of claims 25 to 30, wherein the solar cell is a passivated contact solar cell, which comprises:

a first N-type silicon wafer having a third side and a fourth side opposite to the third side, with the third side being a light-incident side;
a P-type diffusion layer arranged on the third side;
a dielectric layer comprising an aluminum oxide layer and an aluminum oxynitride layer sequentially stacked, with the aluminum oxide layer being arranged on a side of the P-type diffusion layer facing away from the first N-type silicon wafer;
a third protective layer arranged on a side of the aluminum oxynitride layer facing away from the first N-type silicon wafer;
a first tunneling oxide layer arranged on the fourth side;
a first doped polysilicon layer arranged on a side of the first tunneling oxide layer facing away from the first N-type silicon wafer;
a first anti-reflection layer arranged on a side of the first doped polysilicon layer facing away from the first N-type silicon wafer; and
a second electrode structure comprising a third electrode and a fourth electrode, with the third electrode being in ohmic contact with the P-type diffusion layer and the fourth electrode being in ohmic contact with the first doped polysilicon layer.

35. The solar cell according to any one of claims 25 to 30, wherein the solar cell is an N-type back contact solar cell, which further comprises:

a second N-type silicon wafer having a fifth side and a sixth side opposite to the fifth side, with the fifth side being a light-incident side;

a second passivation layer arranged on the fifth side;

a fourth protective layer arranged on a side of the second passivation layer facing away from the second N-type silicon wafer;

a second tunneling oxide layer comprising a first part and a second part, with the first part and the second part being arranged on the sixth side;

a second doped polysilicon layer comprising a P-type doped polysilicon layer and an N-type doped polysilicon layer, with the P-type doped polysilicon layer being arranged on a side of the first part facing away from the second N-type silicon wafer and the N-type doped polysilicon layer being arranged on a side of the second part facing away from the second N-type silicon wafer;

a dielectric layer being an aluminum oxynitride layer and comprising a third part, a fourth part, and a fifth part, with the third part being arranged on a side of the P-type doped polysilicon layer facing away from the second N-type silicon wafer, the fourth part being arranged on the sixth side and between the P-type doped polysilicon layer and the N-type doped polysilicon layer, and the fifth part being arranged on a side of the N-type doped polysilicon layer facing away from the second N-type silicon wafer;

a fifth protective layer arranged on sides of the third part, the fourth part, and the fifth part facing away from the second N-type silicon wafer; and

a third electrode structure comprising a fifth electrode and a sixth electrode, with the fifth electrode being in ohmic contact with the P-type doped polysilicon layer and the sixth electrode being in ohmic contact with the N-type doped polysilicon layer.

36. The solar cell according to any one of claims 25 to 30, wherein the solar cell is an N-type back contact solar cell, which comprises:

a second N-type silicon wafer having a fifth side and a sixth side opposite to the fifth side, with the fifth side being a light-incident side;

a second passivation layer arranged on the fifth side;

a fourth protective layer arranged on a side of the second passivation layer facing away from the second N-type silicon wafer;

a second tunneling oxide layer comprising a first part and a second part, with the first part and the second part being arranged on the sixth side;

a second doped polysilicon layer comprising a P-type doped polysilicon layer and an N-type doped polysilicon layer, with the P-type doped polysilicon layer being arranged on a side of the first part facing away from the second N-type silicon wafer and the N-type doped polysilicon layer being arranged on a side of the second part facing away from the second N-type silicon wafer;

a dielectric layer comprising a third part, a fourth part, and a fifth part, where

the third part comprises a first aluminum oxide layer and a first aluminum oxynitride layer sequentially stacked, with the first aluminum oxide layer being arranged on a side of the P-type doped polysilicon layer facing away from the second N-type silicon wafer,

the fourth part comprises a second aluminum oxide layer and a second aluminum oxynitride layer sequentially stacked, with the second aluminum oxide layer being arranged on the sixth side and between the P-type doped polysilicon layer and the N-type doped polysilicon layer,

the fifth part comprises a third aluminum oxide layer and a third aluminum oxynitride layer sequentially stacked, with the third aluminum oxide layer being arranged on a side of the N-type doped polysilicon layer facing away from the second N-type silicon wafer; and

a fifth protective layer arranged on sides of the first aluminum oxynitride layer, the second aluminum oxynitride layer, and the third aluminum oxynitride layer facing away from the second N-type silicon wafer; and

a third electrode structure comprising a fifth electrode and a sixth electrode, with the fifth electrode being in ohmic contact with the P-type doped polysilicon layer and the sixth electrode being in ohmic contact with the N-type doped polysilicon layer.

37. The solar cell according to any one of claims 25 to 30, wherein the solar cell is a P-type back contact solar cell, which comprises:

a second P-type silicon wafer having a seventh side and an eighth side opposite to the seventh side, with the seventh side being a light-incident side;

a third passivation layer arranged on the seventh side;

a sixth protective layer arranged on a side of the third passivation layer facing away from the second P-type silicon wafer;

a third tunneling oxide layer arranged on the eighth side;

an N-type doped polysilicon layer arranged on a side of the third tunneling oxide layer facing away from the second P-type silicon wafer;

a dielectric layer being an aluminum oxynitride layer and comprising a sixth part and a seventh part, with the sixth part being arranged on the eighth side and the seventh part being arranged on a side of the N-type doped polysilicon layer facing away from the second P-type silicon wafer;

a seventh protective layer arranged on sides of the sixth part and the seventh part facing away from the second N-type silicon wafer; and

a fourth electrode structure comprising a seventh electrode and an eighth electrode, with the seventh electrode being in ohmic contact with the second P-type silicon wafer and the eighth electrode being in ohmic contact with the N-type doped polysilicon layer.

38. The solar cell according to any one of claims 25 to 30, wherein the solar cell is a P-type back contact solar cell, which comprises:

a second P-type silicon wafer having a seventh side and an eighth side opposite to the seventh side, with the seventh side being a light-incident side;

a third passivation layer arranged on the seventh side;

a sixth protective layer arranged on a side of the third passivation layer facing away from the second P-type silicon wafer;

a third tunneling oxide layer arranged on the eighth side;

an N-type doped polysilicon layer arranged on a side of the third tunneling oxide layer facing away from the second P-type silicon wafer;

a dielectric layer comprising a sixth part and a seventh part, where

the sixth part comprises a fourth aluminum oxide layer and a fourth aluminum oxynitride layer sequentially stacked, with the fourth aluminum oxide layer being arranged on the eighth side, and

the seventh part comprises a fifth aluminum oxide layer and a fifth aluminum oxynitride layer sequentially stacked, with the fifth aluminum oxide layer arranged on a side of the N-type doped polysilicon layer facing away from the second P-type silicon wafer;

a seventh protective layer arranged on sides of the fourth aluminum oxynitride layer and the fifth aluminum oxynitride layer facing away from the second N-type silicon wafer; and

a fourth electrode structure comprising a seventh electrode and an eighth electrode, with the seventh electrode being in ohmic contact with the second P-type silicon wafer and the eighth electrode being in ohmic contact with the N-type doped polysilicon layer.

39. A photovoltaic module, comprising the solar cell according to any one of claims 25 to 38.

chemical adsorption: providing an aluminum source and an oxygen source, which are chemically adsorbed onto the surface of the P-type layer , thereby completeing one growth cycle, and repeating the growth cycle *x* times to deposit the dielectric layer, wherein a nitrogen source is further provided in at least 10 times of the *x* times of the growth cycle, such that the dielectric layer has a nitrogen content greater than 4 wt% and a hydrogen content greater than 4 wt%

standing: allowing the dielectric layer to stand in an inert atmosphere at a temperature greater than or equal to 520°C for a time of 10 min to 40 min

FIG. 1

FIG. 2

FIG. 3

FIG. 4

FIG. 5

FIG. 6

300

33
32

361 362 363
3611 3612 3621 3622 3631 3632

31

341 (34)
351

342 (34)
352

37 37 37

381 382

FIG. 7

400

43
42

41
44
45

47

47

461 462

46

481 482

FIG. 8

FIG. 9

## INTERNATIONAL SEARCH REPORT

| International application No. |
|---|
| **PCT/CN2024/107851** |

### A. CLASSIFICATION OF SUBJECT MATTER

H01L31/0216(2014.01)i; H01L31/068(2012.01)i; H01L31/18(2006.01)i; C23C16/40(2006.01)i; C23C16/455(2006.01)i

According to International Patent Classification (IPC) or to both national classification and IPC

### B. FIELDS SEARCHED

Minimum documentation searched (classification system followed by classification symbols)

IPC: H01L31/-,C23C16/-

Documentation searched other than minimum documentation to the extent that such documents are included in the fields searched

Electronic data base consulted during the international search (name of data base and, where practicable, search terms used)

CNTXT, ENTXTC, VEN, CNKI: 沉积, 氮氧化铝, 电池, 电极, 电介质, 多次, 含氢量, 介电, 氢含量, 三氧化二铝, 太阳, 太阳电池, 循环, 氧化铝, Al2O3, AlON, alumina, amount, battery, cycle, deposition, dielectric, hydrogen, multiple, sun, hydrogen content, aluminum oxynitride, aluminium oxide, solar cell, solar energy

### C. DOCUMENTS CONSIDERED TO BE RELEVANT

| Category* | Citation of document, with indication, where appropriate, of the relevant passages | Relevant to claim No. |
|---|---|---|
| PX | CN 116913984 A (TONGWEI SOLAR (MEISHAN) CO., LTD.) 20 October 2023 (2023-10-20) <br> claims 1-19, and description, paragraphs 3-24, 32, 41, 46, 57, and 91 | 1-39 |
| Y | CN 112133768 A (LONGI SOLAR TECHNOLOGY (TAIZHOU) CO., LTD.) 25 December 2020 (2020-12-25) <br> description, paragraphs 1, 23, 37-38, and 57 | 1-39 |
| Y | CN 113193056 A (HENGDIAN GROUP DMEGC MAGNETICS CO., LTD.) 30 July 2021 (2021-07-30) <br> description, paragraph 3 | 1-39 |
| Y | CN 115832069 A (TONGWEI SOLAR (MEISHAN) CO., LTD.) 21 March 2023 (2023-03-21) <br> description, paragraphs 10-11, 21, 122, and 171 | 25-32, 39 |
| Y | CN 110289333 A (LONGI SOLAR TECHNOLOGY (TAIZHOU) CO., LTD.) 27 September 2019 (2019-09-27) <br> description, paragraphs 5-10 | 33-39 |

☑ Further documents are listed in the continuation of Box C.     ☑ See patent family annex.

| | |
|---|---|
| \* Special categories of cited documents: <br> "A" document defining the general state of the art which is not considered to be of particular relevance <br> "D" document cited by the applicant in the international application <br> "E" earlier application or patent but published on or after the international filing date <br> "L" document which may throw doubts on priority claim(s) or which is cited to establish the publication date of another citation or other special reason (as specified) <br> "O" document referring to an oral disclosure, use, exhibition or other means <br> "P" document published prior to the international filing date but later than the priority date claimed | "T" later document published after the international filing date or priority date and not in conflict with the application but cited to understand the principle or theory underlying the invention <br> "X" document of particular relevance; the claimed invention cannot be considered novel or cannot be considered to involve an inventive step when the document is taken alone <br> "Y" document of particular relevance; the claimed invention cannot be considered to involve an inventive step when the document is combined with one or more other such documents, such combination being obvious to a person skilled in the art <br> "&" document member of the same patent family |

| Date of the actual completion of the international search | Date of mailing of the international search report |
|---|---|
| **09 October 2024** | **22 October 2024** |

| Name and mailing address of the ISA/CN | Authorized officer |
|---|---|
| **China National Intellectual Property Administration (ISA/ CN)** <br> **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

International application No.

**PCT/CN2024/107851**

### C. DOCUMENTS CONSIDERED TO BE RELEVANT

| Category* | Citation of document, with indication, where appropriate, of the relevant passages | Relevant to claim No. |
|---|---|---|
| A | US 2010263725 A1 (INSTITUT FUER SOLARENERGIEFORSCHUNG GMBH) 21 October 2010 (2010-10-21)<br>    entire description | 1-39 |
| A | US 2011297227 A1 (FRAUNHOFER-GESELLSCHAFT ZUR FORDERUNG DER ANGEWANDTEN FORSCHUNG E.V.) 08 December 2011 (2011-12-08)<br>    entire description | 1-39 |

Form PCT/ISA/210 (second sheet) (July 2022)

## INTERNATIONAL SEARCH REPORT
### Information on patent family members

International application No.

**PCT/CN2024/107851**

| Patent document cited in search report | | | Publication date (day/month/year) | Patent family member(s) | | | Publication date (day/month/year) |
|---|---|---|---|---|---|---|---|
| CN | 116913984 | A | 20 October 2023 | CN | 116913984 | B | 30 January 2024 |
| CN | 112133768 | A | 25 December 2020 | WO | 2020258884 | A1 | 30 December 2020 |
| | | | | CN | 112216766 | A | 12 January 2021 |
| CN | 113193056 | A | 30 July 2021 | CN | 214672634 | U | 09 November 2021 |
| | | | | WO | 2022242063 | A1 | 24 November 2022 |
| | | | | KR | 20230164747 | A | 04 December 2023 |
| | | | | EP | 4310922 | A1 | 24 January 2024 |
| | | | | JP | 2024514910 | W | 03 April 2024 |
| | | | | US | 2024194801 | A1 | 13 June 2024 |
| CN | 115832069 | A | 21 March 2023 | CN | 115832069 | B | 23 July 2024 |
| | | | | WO | 2024169850 | A1 | 22 August 2024 |
| CN | 110289333 | A | 27 September 2019 | CN | 110289333 | B | 08 February 2022 |
| US | 2010263725 | A1 | 21 October 2010 | ES | 2523441 | T3 | 26 November 2014 |
| | | | | EP | 2220689 | A2 | 25 August 2010 |
| | | | | EP | 2220689 | B1 | 27 August 2014 |
| | | | | WO | 2009062882 | A2 | 22 May 2009 |
| | | | | WO | 2009062882 | A3 | 08 July 2010 |
| | | | | PT | 2220689 | E | 24 November 2014 |
| | | | | MY | 152398 | A | 15 September 2014 |
| | | | | US | 9893215 | B2 | 13 February 2018 |
| | | | | DE | 102007054384 | A1 | 20 May 2009 |
| | | | | HRP | 20141036 | T1 | 30 January 2015 |
| | | | | AU | 2008323025 | A1 | 22 May 2009 |
| | | | | AU | 2008323025 | B2 | 13 March 2014 |
| | | | | AU | 2008323025 | C1 | 24 September 2020 |
| US | 2011297227 | A1 | 08 December 2011 | EP | 2329528 | A2 | 08 June 2011 |
| | | | | EP | 2329528 | B1 | 12 October 2016 |
| | | | | JP | 2012502450 | A | 26 January 2012 |
| | | | | DE | 102008045522 | A1 | 04 March 2010 |
| | | | | KR | 20110069008 | A | 22 June 2011 |
| | | | | WO | 2010025809 | A2 | 11 March 2010 |
| | | | | WO | 2010025809 | A8 | 06 May 2010 |
| | | | | WO | 2010025809 | A3 | 21 October 2010 |
| | | | | WO | 2010025809 | A9 | 16 June 2016 |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 2023111688368